(19) Europäisches Patentamt
European Patent Office
Office européen des brevets

(11) **EP 4 293 690 A1**

(12) **EUROPEAN PATENT APPLICATION**
published in accordance with Art. 153(4) EPC

(43) Date of publication:
**20.12.2023 Bulletin 2023/51**

(21) Application number: **22752762.9**

(22) Date of filing: **09.02.2022**

(51) International Patent Classification (IPC):
**H01F 10/20** [(2006.01)]     **H01F 1/00** [(2006.01)]
**H01F 1/34** [(2006.01)]     **H01F 41/16** [(2006.01)]
**H05K 9/00** [(2006.01)]

(52) Cooperative Patent Classification (CPC):
**H01F 1/00; H01F 1/34; H01F 10/20; H01F 41/16; H05K 9/00**

(86) International application number:
**PCT/JP2022/005026**

(87) International publication number:
**WO 2022/172939 (18.08.2022 Gazette 2022/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.02.2021   JP 2021018761**
**07.02.2022   JP 2022017459**
**08.02.2022   JP 2022018310**

(71) Applicant: **Powdertech Co., Ltd.**
**Kashiwa-shi, Chiba 277-8557 (JP)**

(72) Inventors:
• **ISHII, Kazutaka**
**Kashiwa-shi, Chiba 277-8557 (JP)**
• **AGA, Koji**
**Kashiwa-shi, Chiba 277-8557 (JP)**

(74) Representative: **Vossius & Partner**
**Patentanwälte Rechtsanwälte mbB**
**Siebertstraße 3**
**81675 München (DE)**

(54) **MAGNETIC COMPOSITE**

(57)     Provided is a magnetic composite including a ferrite layer that is dense, has a relatively large film thickness, is excellent in magnetic properties and electrical properties, and further has good adhesion.

The magnetic composite includes a resin base material and a ferrite layer provided on a surface of the resin base material. In the magnetic composite, the resin base material has a thickness ($d_R$) of 10 $\mu$m or more, and the ferrite layer has a thickness ($d_F$) of 2.0 $\mu$m or more, contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis.

FIG. 9

EP 4 293 690 A1

**Description**

TECHNICAL FIELD

The present invention relates to a magnetic composite.

BACKGROUND ART

With a rapid progress of electronic information and communication technology in recent years, utilization of electromagnetic waves is rapidly increasing, and frequency increasing and band widening of electromagnetic waves to be used have been advancing. Specifically, in addition to a system in a quasi-microwave band represented by mobile phones (1.5, 2.0 GHz) and a wireless LAN (2.45 GHz), introduction of a new system utilizing radio waves in an extremely high frequency band such as a high-speed wireless LAN (65 GHz) and a collision-prevention radar (76.5 GHz) is advancing.

As utilization extension and the frequency increasing of the electromagnetic waves are advanced, problems of electromagnetic interference such as malfunction of an electronic device and an adverse effect on a human body caused by electromagnetic noise are closed up, and there is an increasing demand for a countermeasure against EMC. As a method for the countermeasure against EMC, there is known a method of absorbing unnecessary electromagnetic waves using an electromagnetic wave absorber (radio wave absorber) to prevent intrusion of the electromagnetic waves.

For the electromagnetic wave absorber, a material exhibiting conductive loss, dielectric loss, and/or magnetic loss is used. As a material exhibiting magnetic loss, ferrite having high permeability and high electric resistance is frequently used. The ferrite has a function of causing a resonance phenomenon at a specific frequency to absorb an electromagnetic wave, converts absorbed electromagnetic wave energy into thermal energy, and radiates the thermal energy to an outside. As an electromagnetic wave absorber using ferrite, a composite material or a ferrite thin film containing ferrite powder and a binder resin has been proposed. In addition, a technique of forming a ferrite film on a substrate is known in applications other than the electromagnetic wave absorber.

For example, Patent Literature 1 discloses an electromagnetic wave absorber having a ferromagnetic material physically deposited on a substrate made of an organic macromolecular, and discloses that the electromagnetic wave absorber has good electromagnetic wave absorption properties, a small size, light weight, flexibility, and fastness (claim 1 and paragraph [0008]). In addition, Patent Literature 1 discloses that an oxide-based soft magnetic material is mainly used as the ferromagnetic material, ferrite is preferable as the oxide-based soft magnetic material, and examples of physical vapor deposition include EB vapor deposition, ion plating, magnetron sputtering, and counter target type magnetron sputtering (paragraphs [0009], [0010], and [0017]).

Patent Literature 2 discloses a composite structure of a resin and a brittle material, in which a foundation layer made of an adhesive material that adheres to a surface of a resin substrate is formed, and a polycrystalline brittle material layer such as ferrite is formed on the whole or part of the foundation layer (claim 1). In addition, Patent Literature 2 discloses that ferrite fine particles having a purity of 99% or more and a submicron particle diameter were sprayed on a plastic substrate by a fine particle beam deposition method to attempt to form a structure, a radio wave absorbing effect was examined, and even a brittle material such as ferrite is stably combined on a resin base material (paragraphs [0036] and [0055] to [0059]).

Patent Literature 3 discloses that a radio wave absorber is manufactured using an AD method or a ferrite plating method (paragraphs [0020] to [0022]). Specifically, Patent Literature 3 discloses that a ferrite base material having a film thickness of 5 $\mu$m is prepared by blending ferrite raw material powder such that a composition of a ferrite base material becomes $Ni_{0.5}Zn_{0.5}Fe_2O_4$, mixing the ferrite raw material powder with a mixer, then supplying the mixture to a nozzle, adjusting a pressure in a chamber to 7 Pa to spray aerosolized ferrite raw material powder at a flow rate of 5L/min from a tip of the nozzle to a substrate constituting of a polyimide resin, and sixteen holes having a diameter of 2 $\mu$m are formed in the ferrite base material by an etching treatment to obtain a radio wave absorber (paragraph [0020]).

PRIOR ART DOCUMENTS

PATENT LITERATURES

Patent Literature 1: JP2005-045193A
Patent Literature 2: JP2006-175375A
Patent Literature 3: JP2006-269675A

SUMMARY OF INVENTION

PROBLEMS TO BE SOLVED BY THE INVENTION

As described above, although it has been proposed to apply a composite prepared by forming a ferrite-containing layer on a substrate to applications such as an electromagnetic wave absorber, there is room for improvement in techniques in the conventional art. For example, the electromagnetic wave absorber proposed in Patent Literature 1 is formed into a film by physical vapor deposition, and it is difficult to form the electromagnetic wave absorber into a thick film in view of manufacture, and there is a limit in enhancing magnetic properties such as electromagnetic wave absorption properties. In addition, even when a thick film can be formed, there is a problem that the film is easily peeled off from a base material. In order to prepare the composite structure in Patent Literature 2, it is necessary to previously form a foundation layer from an adhesive material on a surface of a base material. Since such a foundation layer is inferior in heat resistance, there is a problem that the composite structure lacks in thermal stability. In addition, there is also a problem that a manufacturing process becomes complicated and manufacture of the composite structure is difficult. Further, fine brittle material particles are used as a raw material in examples, and there is a problem that the obtained brittle material layer lacks in density. Patent Literature 3 does not disclose detailed manufacturing conditions such as a particle diameter of the ferrite raw material powder, and it is unclear to what degree of density and properties the obtained radio wave absorber has.

The present inventors have conducted intensive studies in view of such problems. As a result, it was found that in a magnetic composite including a resin base material and a ferrite layer, a crystalline state of the ferrite layer is important, and by controlling the crystalline state, it is possible to obtain a ferrite layer that is dense, has a relatively large film thickness, is excellent in magnetic properties and electrical properties, and further has good adhesion.

The present invention has been accomplished on the basis of such findings, and an object of the present invention is to provide a magnetic composite including a ferrite layer that is dense, has a relatively large film thickness, is excellent in magnetic properties and electrical properties, and further has good adhesion.

MEANS FOR SOLVING THE PROBLEMS

The present invention encompasses the following embodiments (1) to (7). In the present description, the expression "to" includes numerical values at both ends thereof. Thus, "X to Y" has the same meaning as "X or more and Y or less".

(1) The magnetic composite includes a resin base material and a ferrite layer provided on a surface of the resin base material, in the magnetic composite,

the resin base material has a thickness ($d_R$) of 10 $\mu$m or more, and
the ferrite layer has a thickness ($d_F$) of 2.0 $\mu$m or more, contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis.

(2) The magnetic composite according to the above-mentioned (1), in which in the ferrite layer, a content of $\alpha$-$Fe_2O_3$ is 0.0 mass% or more and 20.0 mass% or less.

(3) The magnetic composite according to the above-mentioned (1) or (2), in the magnetic composite, the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

(4) The magnetic composite according to any one of the above-mentioned (1) to (3), in which in the ferrite layer, a ratio ($Sa/d_F$) of a surface arithmetic mean height (Sa) to the thickness ($d_F$) is more than 0.00 and 0.20 or less.

(5) The magnetic composite according to any one of the above-mentioned (1) to (4), in the magnetic composite, the ferrite layer has a composition including a ferrite component and the remainder being inevitable impurities.

(6) The magnetic composite according to any one of the above-mentioned (1) to (5), in which a specific gravity of a resin constituting the resin base material is 0.95 g/cm$^3$ or more.

(7) The magnetic composite according to any one of the above-mentioned (1) to (6), in which the resin constituting the resin base material is at least one selected from the group consisting of polycarbonate (PC), polyimide (PI), polyvinyl chloride (PVC), polyoxymethylene (POM), acrylonitrile butadiene styrene (ABS), polyetheretherketone (PEEK), and polyamide (PA).

EFFECTS OF INVENTION

According to the present invention, there is provided a magnetic composite including a ferrite layer that is dense, has a relatively large film thickness, is excellent in magnetic properties and electrical properties, and further has good adhesion.

BRIEF DESCRIPTION OF DRAWINGS

Fig. 1 illustrates an embodiment of a magnetic composite.
Fig. 2 illustrates another embodiment of the magnetic composite.
Fig. 3 illustrates yet another embodiment of the magnetic composite.
Fig. 4 illustrates still another embodiment of the magnetic composite.
Fig. 5 illustrates an example in which the magnetic composite is applied to an inductor.
Fig. 6 illustrates another example in which the magnetic composite is applied to an inductor.
Fig. 7 illustrates still another example in which the magnetic composite is applied to an inductor.
Fig. 8 illustrates an example in which the magnetic composite is applied to an antenna element (UHF-ID tag).
Fig. 9 illustrates an example of a configuration of an aerosol deposition film forming device.
Fig. 10 illustrates cross-sectional element mapping images of a ferrite layer.
Fig. 11 illustrates permeability (real part $\mu'$ and imaginary part $\mu''$) of the magnetic composite.

EMBODIMENTS FOR CARRYING OUT THE INVENTION

Specific embodiments of the present invention (hereinafter referred to as "the present embodiment") will be described. The present invention is not limited to the following embodiments, and various modifications can be made without departing from the gist of the present invention.

«1. Magnetic Composite»

The magnetic composite of the present embodiment includes a resin base material and a ferrite layer provided on the resin base material. The resin base material has a thickness ($d_R$) of 10 $\mu$m or more. The ferrite layer has a thickness ($d_F$) of 2.0 $\mu$m or more. In addition, the ferrite layer contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis. The magnetic composite will be described in detail below.

A resin constituting the resin base material is not particularly limited. The resin may be a single resin or a mixture or copolymer of two or more kinds of resins. Preferably, the resin is at least one selected from the group consisting of polycarbonate (PC), polyimide (PI), polyvinyl chloride (PVC), polyoxymethylene (POM), acrylonitrile butadiene styrene (ABS), polyetheretherketone (PEEK), and polyamide (PA). These resins have excellent mechanical strength and excellent insulation property.

A specific gravity of the resin constituting the resin base material is preferably 0.95 g/cm$^3$ or more. In a case where the specific gravity is less than 0.95 g/cm$^3$, collision energy when the raw material grains collide with the base material during film formation is easily dispersed, and plastic deformation of the raw material grains hardly occurs. Therefore, it becoms difficult to form the ferrite layer.

A color tone of the resin base material is not limited. For example, a colorless transparent or light-colored resin can be used. In addition, a resin colored to such an extent that light is transmitted may be used. In the magnetic composite prepared using such a resin as a base material, the ferrite layer can be seen through the resin when seen from a surface on which the ferrite layer is not formed. Therefore, in addition to various properties including electromagnetic wave shielding performance, it is possible to impart designability that cannot be obtained when a resin not allowing light to transmit is used to the composite.

A shape of the resin base material is also not limited. The base material may have a sheet shape or a shape other than the sheet shape. For example, a resin base material having a three-dimensionally complicated shape may be used. When a resin base material having such a complicated shape is applied to an accommodation housing of an electric circuit, a housing having excellent mechanical strength can be obtained. In addition, a ferrite layer may be provided on the entire surface of the resin base material, or a ferrite layer may be provided on a part of the surface thereof. For example, a resin base material having a complicated shape may be used, and a ferrite layer may be provided on a part of a surface of the resin base material. Accordingly, electromagnetic wave shielding performance can be imparted to any surface of the accommodation housing having a complicated shape. In the conventional art, in order to impart electromagnetic wave shielding performance to a resin base material having a complicated shape, a work of punching and molding a sheet-shaped resin base material and attaching a ferrite sheet to a punched member is necessary. When the magnetic composite of the present embodiment is used, such a work is not necessary, and therefore, it is possible to prepare a housing having various properties such as electromagnetic wave shielding performance at low cost. In addition, unlike an electromagnetic wave shielding material made of an integral mixture of a resin and a filler, since the resin base material and the ferrite layer are clearly separated from each other, it is possible to provide designability that has not been obtained in the conventional art.

The thickness ($d_R$) of the resin base material is limited to 10 $\mu$m or more (0.01 mm or more). When the resin base material is excessively thin, it becomes difficult to prepare a composite having sufficient mechanical strength. In a case where it is desired to impart bendability (flexibility) thereto, the thickness of the resin base material is preferably 25 $\mu$m or more (0.025 mm or more), and more preferably 35 $\mu$m or more (0.035 mm or more). In a case where it is desired to increase the thickness of the ferrite layer, the thickness is more preferably 35 $\mu$m or more (0.035 mm or more), and particularly preferably 100 $\mu$m or more (0.1 mm or more). The thickness may be 5,000 $\mu$m or more (5 mm or more). On the other hand, an upper limit of the thickness is not limited. However, by appropriately thinning the resin base material, flexibility can be imparted to the magnetic composite. The thickness may be 100,000 $\mu$m or less (100 mm or less), 50,000 $\mu$m or less (50 mm or less), 10,000 $\mu$m or less (10 mm or less), 5,000 $\mu$m or less (5 mm or less), or 1,000 $\mu$m or less (1 mm or less).

In addition, the resin base material may have a plate shape or a sheet shape. However, the resin base material preferably has the sheet shape. By using a sheet-shaped resin base material (resin sheet), a magnetic composite having excellent flexibility can be prepared. In addition, the resin base material may be constituted of only a resin, or may be a laminate of a non-resin base material and a resin layer. In this case, the resin layer laminated on the non-resin base material corresponds to the resin base material. A metal film or the like can be used as the non-resin base material.

When the base material is a laminate constituted of a plurality of layers, a thickness of a layer in direct contact with the ferrite layer corresponds to the thickness of the base material. When the base material is uneven, an arithmetic mean of the thinnest portion and the thickest portion of the base material on which the ferrite layer is formed is defined as the thickness $d_R$ of the base material, and a difference between an arithmetic mean of the thinnest portion and the thickest portion of the composite and the thickness $d_R$ of the base material is defined as the thickness $d_F$ of the ferrite layer. When ferrite layers are formed on both surfaces of the composite, the difference between the arithmetic mean of the thinnest portion and the thickest portion of the composite and the thickness $d_R$ of the base material is regarded as twice the thickness of the ferrite layer, and the thickness $d_F$ is calculated. Thus, when ferrite layers having the same film thickness are formed on both surfaces of the base material, the thickness of the ferrite layer on one surface corresponds to $d_F$. When the thickness $d_R$ of the base material exceeds 2,000 $\mu$m, the thickness ratio ($d_F/d_R$) is calculated by regarding the thickness $d_R$ of the base material as 2,000 $\mu$m.

The ferrite layer of the present embodiment is a polycrystalline containing spinel-type ferrite as a principal component. Thus, the ferrite layer is an aggregate of crystal grains constituting of the spinel-type ferrite. The spinel-type ferrite is a composite oxide of iron (Fe) having a spinel-type crystal structure, most of which exhibit soft magnetism. By including the layer containing the spinel-type ferrite as the principal component, the magnetic composite has excellent magnetic properties. A type of the spinel-type ferrite is not particularly limited. Examples thereof include at least one selected from the group consisting of manganese (Mn) ferrite, manganese-zinc (Mn-Zn) ferrite, magnesium (Mg) ferrite, magnesium-zinc (Mg-Zn) ferrite, nickel (Ni) ferrite, nickel-copper (Ni-Cu) ferrite, nickel-copper-zinc (Ni-Cu-Zn) ferrite, cobalt (Co) ferrite, and cobalt-zinc (Co-Zn) ferrite. In addition, a mixed crystal and/or a solid solution of a plurality of types of ferrite may be used. In the present description, the principal component refers to a component having a content of 50.0 mass% or more. In order to utilize the excellent magnetic properties of the spinel-type ferrite, a content ratio of the spinel-type ferrite (ferrite phase) in the ferrite layer is preferably 60.0 mass% or more, more preferably 70.0 mass% or more, still more preferably 80.0 mass% or more, and particularly preferably 90.0 mass% or more.

The thickness ($d_F$) of the ferrite layer of the present embodiment is limited to 2.0 $\mu$m or more. When the ferrite layer is excessively thin, a film thickness of the ferrite layer becomes non-uniform, and there is a concern that magnetic properties and electrical properties (electric insulation) deteriorate. The thickness is preferably 3.0 $\mu$m or more, and more preferably 3.5 $\mu$m or more. The thickness may be 5.0 $\mu$m or more, 6.0 $\mu$m or more, or 7.0 $\mu$m or more. An upper limit of the thickness is not limited. However, it is difficult to form a film of an excessively thick ferrite layer while maintaining density thereof. In addition, when the ferrite layer is excessively thick, internal stress of the ferrite layer becomes excessively large, and there is a concern that the ferrite layer is peeled off. Further, when flexibility is imparted to the magnetic composite, it is desirable that the ferrite layer is appropriately thin. The thickness is preferably 100.0 $\mu$m or less, more preferably 50.0 $\mu$m or less, still more preferably 20.0 $\mu$m or less, and particularly preferably 10.0 $\mu$m or less. In addition, it is preferable that the ferrite layer is in direct contact with the resin base material, that is, another layer is not interposed between the ferrite layer and the resin base material.

In the ferrite layer of the present embodiment, the ratio ($I_{222}/I_{311}$) of the integrated intensity ($I_{222}$) of the (222)

plane to the integrated intensity ($I_{311}$) of the (311) plane in the X-ray diffraction (XRD) analysis is 0.00 or more and 0.03 or less ($0.00 \leq I_{222}/I_{311} \leq 0.03$). Thus, when the ferrite layer is analyzed by an X-ray diffraction method, a diffraction peak based on the (222) plane of a spinel phase is hardly observed in an X-ray diffraction profile. This is because the crystal grains constituting the ferrite layer are constituted of microcrystals. The crystal grains of the ferrite layer of the present embodiment undergo plastic deformation during manufacturing of the magnetic composite. Therefore, a crystallite diameter is small, and distribution of lattice constants is wide. As a result, an XRD peak becomes broad, and the (222) diffraction peak is not observed. $I_{222}/I_{311}$ is preferably 0.02 or less, and more preferably 0.01 or less. In contrast, a common spinel-type ferrite material has high crystallinity even in a polycrystalline state. Therefore, the (222) plane diffraction peak is relatively strongly observed. Specifically, an XRD peak intensity ratio ($I_{222}/I_{311}$) is about 0.04 to 0.05 (4% to 5%).

The ferrite layer of the present embodiment having a small XRD peak intensity ratio ($I_{222}/I_{311}$) is characterized by being dense. This is because the crystal grains undergone the plastic deformation are easily densely packed. In addition, the ferrite layer of the present embodiment has an effect of being excellent in adhesion to the resin base material. This is because a contact area with the resin base material is increased by the plastic deformation of the crystal grains. In addition, it is considered that the reason also includes that bonding to a resin constituting the base material becomes strong due to the small crystallite diameter and a crystal structure in which the periodicity is disturbed. Further, the ferrite layer of the present embodiment has small magnetic loss ($\tan\delta$) in a high-frequency region of 500 MHz or more. It is presumed that the reason is that a correlation length of a magnetic moment becomes short due to the small crystallite diameter, and as a result, magnetic domain wall displacement is smoothly performed in the high-frequency region. In contrast, in a common spinel-type ferrite material, the correlation length of the magnetic moment is long. The magnetic domain wall displacement by an external magnetic field can be performed in a low-frequency region, but in a high-frequency region of 100 MHz or more, the magnetic domain wall displacement cannot follow fluctuation of the external magnetic field, and the magnetic loss increases.

Preferably, the crystallite diameter of the ferrite layer is 1 nm or more and 10 nm or less. By reducing the crystallite diameter to 10 nm or less, the density and the adhesion of the ferrite layer are further increased, and an effect of preventing an increase in magnetic loss is further remarkable. In addition, by setting the crystallite diameter to 1 nm or more, it is possible to prevent the ferrite layer from becoming amorphous and the magnetic properties from deteriorating. The crystallite diameter is more preferably 1 nm or more and 5 nm or less, still more preferably 1 nm or more and 3 nm or less, particularly preferably 1 nm or more and 2 nm or less.

Preferably, a lattice constant of the spinel-type ferrite contained in the ferrite layer is 8.30 Å or more and 8.80 Å or less. By setting the lattice constant to 8.30 Å or more and 8.80 Å or less, an effect of enhancing magnetic properties of raw material grains can be obtained. The lattice constant is more preferably 8.30 Å or more and 8.60 Å or less, and still more preferably 8.30 Å or more and 8.50 Å or less.

Preferably, the ratio ($d_F/d_R$) of the thickness ($d_F$) of the ferrite layer to the thickness ($d_R$) of the resin base material is 0.0001 or more and 0.5000 or less. When the thickness ratio ($d_F/d_R$) is excessively small, the film thickness of the ferrite layer becomes non-uniform, and the magnetic properties and the electrical properties (electric insulation) deteriorate. The thickness ratio ($d_F/d_R$) is more preferably 0.0010 or more. On the other hand, when the thickness ratio ($d_F/d_R$) is excessively large, the resin base material cannot resist the internal stress of the ferrite layer, and the resin composite may be curved. The thickness ratio ($d_F/d_R$) is more preferably 0.4000 or less, still more preferably 0.3000 or less, particularly preferably 0.2000 or less. When a laminate of a non-resin base material and a resin layer is used, a thickness of the resin layer corresponds to the thickness of the resin base material.

Preferably, in the ferrite layer, a content of $\alpha$-Fe$_2$O$_3$ (hematite) is 0.0 mass% or more and 20.0 mass% or less. The $\alpha$-Fe$_2$O$_3$ is a free iron oxide that did not become a spinel phase. Unlike the spinel phase which is a ferromagnetic material, $\alpha$-Fe$_2$O$_3$ is an antiferromagnetic material and hardly exhibits magnetism to the outside. Therefore, when an amount of $\alpha$-Fe$_2$O$_3$ is excessively large, the magnetic properties of the ferrite layer may deteriorate. The amount of $\alpha$-Fe$_2$O$_3$ is more preferably 15.0 mass% or less, and still more preferably 10.0 mass% or less. Meanwhile, $\alpha$-Fe$_2$O$_3$ is a stable compound having high electric resistance. By appropriately containing $\alpha$-Fe$_2$O$_3$ in the ferrite layer, a conductive path in the ferrite layer can be disconnected, and the electric resistance can be further increased. In particular, the manganese (Mn) ferrite and the manganese-zinc (Mn-Zn) ferrite contain manganese (Mn) ions and iron (Fe) ions having unstable coefficients, and thus tend to have low electric resistance. Accordingly, by containing $\alpha$-Fe$_2$O$_3$ in the ferrite, an effect of improving the electric resistance can be remarkably exhibited. In addition, by appropriately containing $\alpha$-Fe$_2$O$_3$, densification of the ferrite layer and improvement in adhesion can be achieved. The $\alpha$-Fe$_2$O$_3$ is generated in a film forming process of a ferrite layer during the manufacturing of the magnetic composite. Thus, the plastic deformation and reoxidation of the ferrite crystal grains occur when the film forming process is performed, and $\alpha$-Fe$_2$O$_3$ is generated. The plastic deformation and the reoxidation play an important role for densification of the ferrite layer and enhancement of the adhesion. Therefore, the ferrite layer appropriately containing $\alpha$-Fe$_2$O$_3$ has high density and adhesion. The amount of $\alpha$-Fe$_2$O$_3$ is more preferably 0.1 mass% or more, still more preferably 0.5 mass% or more, particularly preferably 1.0 mass% or more, and most preferably 5.0 mass% or more.

Preferably, the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

Preferably, in the ferrite layer, a ratio $(Sa/d_F)$ of a surface arithmetic mean height (Sa) to the thickness $(d_F)$ is more than 0.00 and 0.20 or less ($0.00 < Sa/d_F \leq 0.20$). When the roughness ratio $(Sa/d_F)$ is excessively large, the film thickness of the ferrite layer tends to be non-uniform. Therefore, an electric field is locally concentrated when a high voltage is applied, and a leakage current may be generated. The roughness ratio $(Sa/d_F)$ is more preferably more than 0.00 and 0.15 or less, still more preferably more than 0.00 and 0.10 or less, and particularly preferably more than 0.00 and 0.05 or less.

The ferrite layer of the present embodiment has a relatively high density. The reason is that the ferrite crystal grains constituting the ferrite layer were repeatedly subjected to the plastic deformation, and as a result, those having small crystallite diameter were deposited as the ferrite layer. A relative density of the ferrite layer (density of ferrite layer/true specific gravity of ferrite powder) is preferably 0.40 (40%) or more, more preferably 0.60 (60%) or more, still more preferably 0.70 (70%) or more, still more preferably 0.80 (80%) or more, particularly preferably 0.90 (90%) or more, most preferably 0.95 (95%) or more. By increasing the density, an effect of improving the magnetic properties, the electrical properties, and the adhesion of the ferrite layer becomes more remarkable.

The ferrite layer of the present embodiment has a relatively high electric resistance. The reason is that since the density of the ferrite layer is high, adsorption of a conductive component such as moisture which causes deterioration in electric resistance is small. It is also considered that the small crystallite diameter of the ferrite crystal grains constituting the ferrite layer has an effect thereon. Actually, a volume resistance of a common Mn-Zn ferrite material is about $10^3\,\Omega$. In contrast, the ferrite layer of the present embodiment exhibits a higher resistance value, and a cause thereof can be found in a size of the crystallite diameter. Further, by containing an appropriate amount of $\alpha$-$Fe_2O_3$, the electric resistance of the ferrite layer can be further increased. A surface resistance of the ferrite layer is preferably $10^4\,\Omega$ or more, more preferably $10^5\,\Omega$ or more, still more preferably $10^6\,\Omega$ or more. By increasing the surface resistance, the insulation property of the ferrite layer can be made excellent, and in a case where the magnetic composite is applied to a device, problems such as generation of an eddy current can be prevented.

The ferrite layer preferably has a composition including a ferrite component and the remainder being inevitable impurities. Thus, it is preferable that organic components and inorganic components other than the ferrite component are not contained in excess of an amount of the inevitable impurities. The ferrite layer of the present embodiment can be made sufficiently dense without adding a resin component such as a binder or an inorganic additive component such as a sintering aid. By limiting a content of a nonmagnetic material to the minimum, excellent magnetic properties based on ferrite can be sufficiently utilized. The ferrite component is a component constituting the spinel-type ferrite as a principal component. For example, in a case where the ferrite layer contains manganese-zinc (Mn-Zn) ferrite as the principal component, the ferrite component includes iron (Fe), manganese (Mn), zinc (Zn), and oxygen (O). In a case where the ferrite layer contains nickel-copper-zinc (Ni-Cu-Zn) ferrite as the principal component, the ferrite component includes iron (Fe), nickel (Ni), copper (Cu), zinc (Zn), and oxygen (O). Further, the inevitable impurities are components that are inevitably mixed during manufacturing, and a content thereof is typically 1,000 ppm or less. In particular, the ferrite layer preferably contains no component other than an oxide, particularly a resin component.

The magnetic composite is preferably manufactured by a method including: a process (preparation process) of preparing a resinbase material and a spinel-type ferrite powder having an average particle diameter (D50) of 2.5 $\mu$m or more and 10.0 $\mu$m or less; and a process (film forming process) of forming a film of the ferrite powder on a surface of the resin base material by an aerosol deposition method, and in the method, a ratio (LCf/LCp) of a lattice constant (LCf) of a spinel phase contained in a ferrite layer to a lattice constant (LCp) of a spinel phase contained in the spinel-type ferrite powder is 0.95 or more and 1.0.5 or less ($0.95 \leq LCf/LCp \leq 1.05$).

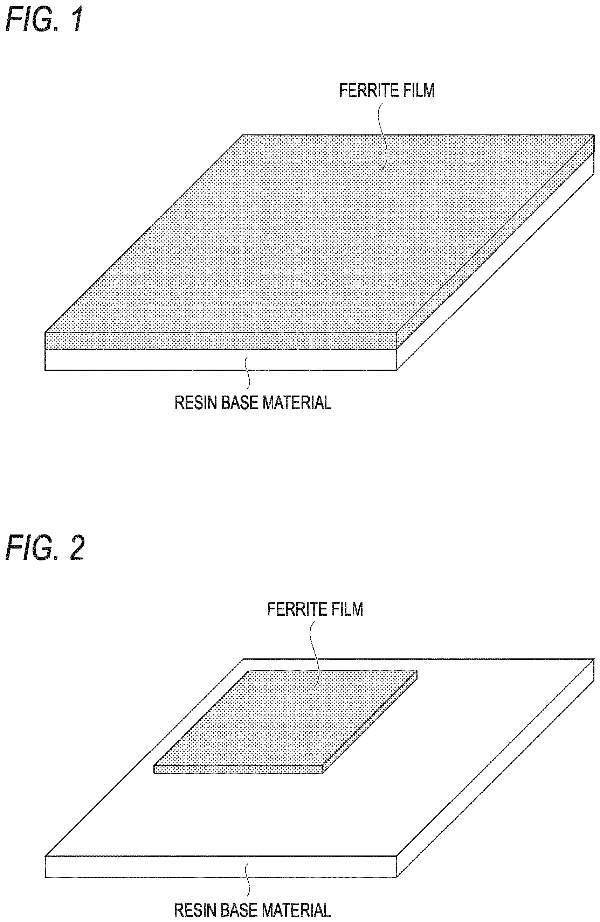

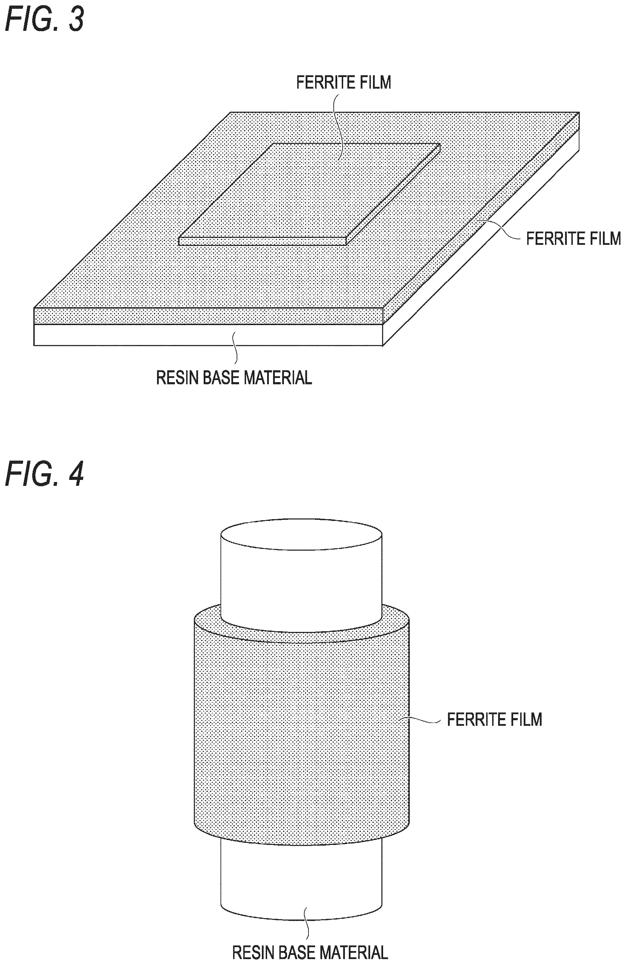

A form of the magnetic composite is also not particularly limited. As illustrated in Fig. 1, the ferrite layer (ferrite film) may be provided on the entire surface of the resin base material. As illustrated in Fig. 2, the ferrite layer may be provided only on a part of the surface of the resin base material. The ferrite layer may be provided not only on one surface of the resin base material but also on both surfaces thereof. As illustrated in Fig. 3, a ferrite layer having a partially changed thickness may be provided on the surface of the resin base material. Further, as illustrated in Fig. 4, the ferrite layer may be wound around an outer periphery of a rod-shaped resin base material.

The magnetic composite can be applied to various applications. Examples of such applications include an element or component including a coil provided with the magnetic composite and/or having an inductor function, an electronic device, an electronic component accommodation housing, an electromagnetic wave absorber, an electromagnetic wave shield, or an element or component having an antenna function.

In this regard, an inductor element in the conventional art is generally surface-mounted on a circuit board as an electronic component. In contrast, in the case of the magnetic composite of the present embodiment, the inductor element can be provided inside an electronic board or a flexible printed wiring board (FPC board). This contributes to miniaturization of the electronic device. In addition, since the magnetic composite can have flexibility, an electronic circuit can be formed on a substrate having a complicated shape that cannot be mounted by a technique in the conventional art.

In preparation of the electromagnetic wave shielding material, a shielding material punched into a specific shape is generally attached to a specific location of a completed circuit board. In contrast, when a composite magnetic material of the present embodiment is used, it is possible to integrally prepare the circuit board in a state where an electromagnetic wave shielding function is included in a specific portion.

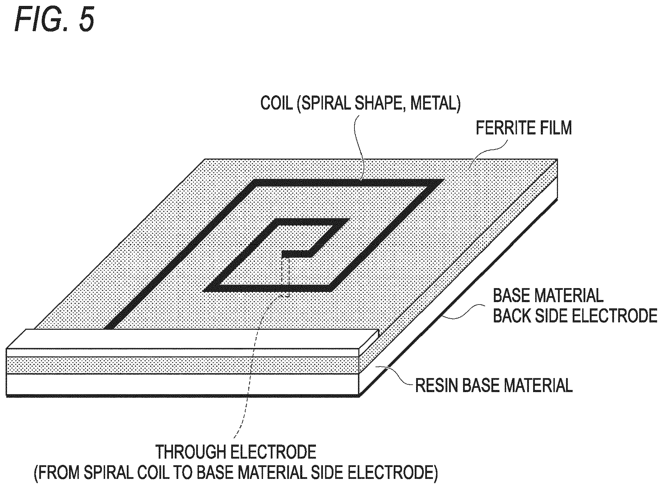

Fig. 5 illustrates an example in which the magnetic composite is applied to an inductor. The magnetic composite includes a resin base material, a ferrite layer (ferrite film) provided on one surface of the resin base material, and a coil provided on a surface of the ferrite layer. In addition, a back side electrode is provided on a back surface side of the resin base material. The coil is made of a conductive material such as metal. In addition, the coil has a spiral-shaped planar circuit pattern, and the coil is formed such that an axial direction of the coil is perpendicular to the surface of the ferrite layer. As a result, the coil exhibits an inductor function. The circuit pattern of the coil may be formed by a method such as electroless plating, screen printing using a paste containing colloidal metal particles, ink jet, sputtering, or vapor deposition. By forming the circuit pattern on the ferrite layer, an element having a mild inductor function can be obtained.

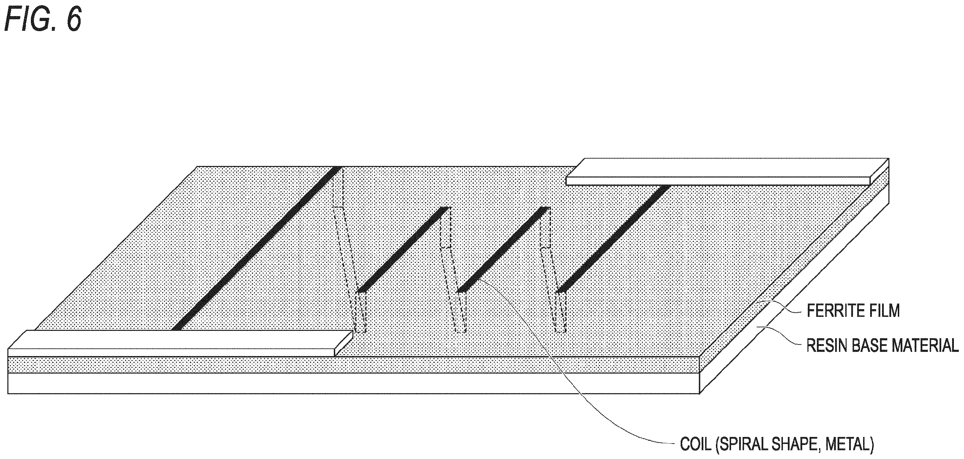

Fig. 6 illustrates another example in which the magnetic composite is applied to an inductor. In this example, a winding coil is formed so as to wind around in a thickness direction of the magnetic composite. Thus, the magnetic composite includes a front surface electrode, a back surface electrode, and a through electrode connecting the front surface electrode and the back surface electrode, and a circuit pattern having a winding coil shape is formed by these electrodes. In this example, the coil is formed such that the axial direction of the coil is parallel to the surface of the ferrite layer.

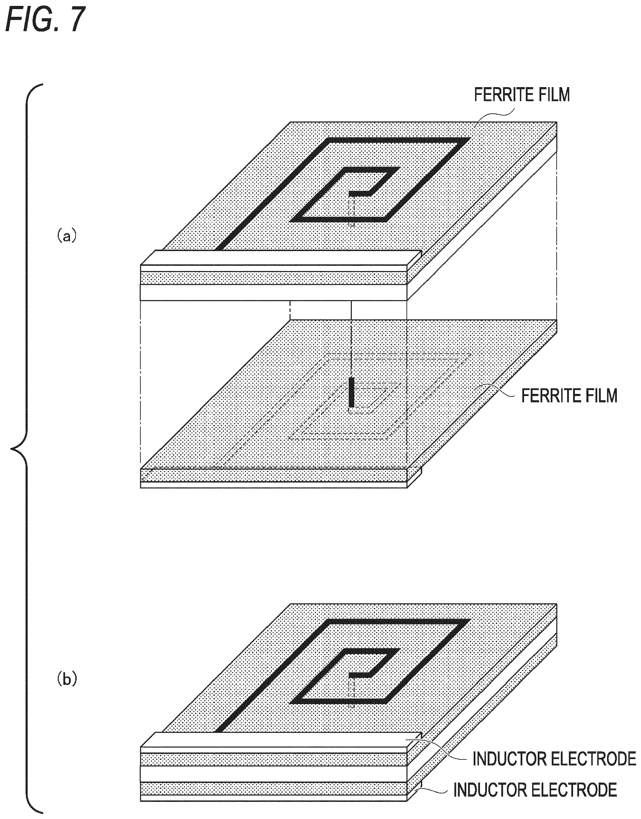

Fig. 7 illustrates still another example in which the magnetic composite is applied to an inductor. In this example, ferrite layers (ferrite films) and coils are provided on both front and back surfaces of the resin base material. The coil on a front surface side and the coil on a back surface side are electrically connected to each other through a through electrode provided in the resin base material and the ferrite layers. By imparting an inductor function to both surfaces of the resin base material, it is possible to prepare a miniaturized inductor.

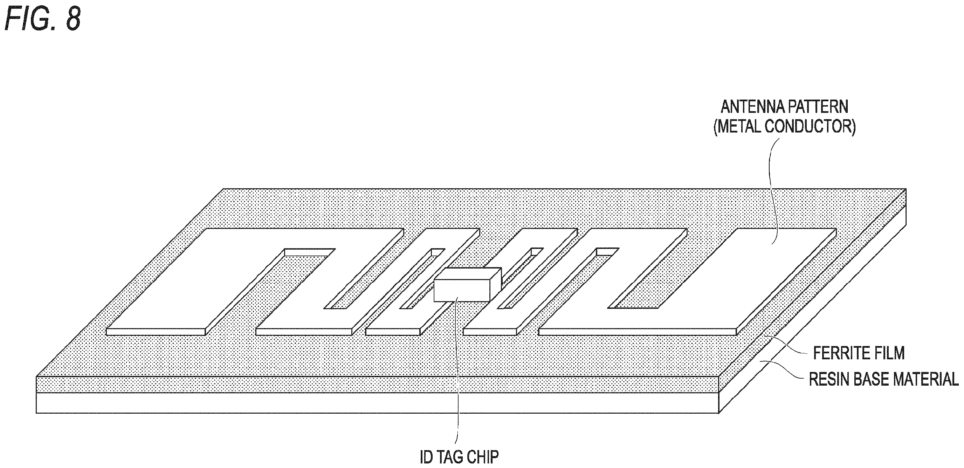

Fig. 8 illustrates an example in which the magnetic composite is applied to an antenna element (UHF-ID tag). The antenna element (magnetic composite) includes a resin base material, a ferrite layer (ferrite film) provided on one surface of the resin base material, a metal conductor provided on one surface of the ferrite layer, and an ID tag chip mounted on the metal conductor. The metal conductor provided on the surface of the ferrite layer is patterned to form an antenna pattern. Since the ferrite layer has higher permeability than a surrounding space, electromagnetic waves are likely to be collected in the ferrite layer. Antenna sensitivity can be improved by providing the antenna pattern on the ferrite layer.

«2. Manufacturing Method for Magnetic Composite»

A manufacturing method for the magnetic composite of the present embodiment is not limited as long as the above-described requirements are satisfied. However, a preferable manufacturing method includes the following processes; a process (preparation process) of preparing a resin base material and a spinel-type ferrite powder having an average particle diameter (D50) of 2.5 $\mu$m or more and 10.0 $\mu$m or less; and a process (film forming process) of forming a film of the ferrite powder on a surface of the resin base material by an aerosol deposition method.

As described above, a relatively thick ferrite layer can be prepared at a high film forming rate by forming the film by the aerosol deposition method (AD method) using ferrite powder having a specific particle diameter as a raw material. The ferrite layer is dense, has excellent magnetic properties and electrical properties, and is excellent in adhesion to the base material. Therefore, the manufacturing method for the magnetic composite is suitable. Each process will be described in detail below.

<Preparation Process>

In the preparation process, the resin base material and the spinel-type ferrite powder are prepared. Details of the resin base material are as described above. On the other hand, as the spinel-type ferrite powder, power having an average particle diameter (D50) of 2.5 $\mu$m or more and 10.0 $\mu$m or less is prepared. The average particle diameter is preferably 2.5 $\mu$m or more and 7.0 $\mu$m or less. By adjusting the average particle diameter within the above-mentioned range, a dense ferrite layer having high adhesion can be obtained in the subsequent film forming process.

A method for preparing the ferrite powder is not limited. However, it is preferable that a ferrite raw material mixture is subjected to sintering in an atmosphere having an oxygen concentration lower than that of the air to prepare a sintered product, and the obtained sintered product is pulverized to prepare particles having a specific particle diameter and an irregular shape. Before the sintering, the ferrite raw material mixture may be subjected to calcination, pulverization, and/or granulation treatment. As a ferrite raw material, a known ferrite raw material such as an oxide, a carbonate, and a hydroxide may be used.

A shape of the ferrite powder is preferably an irregular shape. Specifically, an average value of a shape factor (SF-2) of the ferrite powder is preferably 1.02 or more and 1.50 or less, more preferably 1.02 or more and 1.35 or less, and still more preferably 1.02 or more and 1.25 or less. Here, SF-2 is an index indicating a degree of irregularity of the particles, and the closer SF-2 is to 1, the more spherical the shape is, and the larger SF-2 is, the more irregular the shape is. When SF-2 is excessively small, the particles are excessively rounded. Therefore, biting of the particles to the base material becomes worse, and the film forming rate cannot be increased. On the other hand, when SF-2 is excessively large, unevenness of a particle surface becomes excessively large. Therefore, although the film forming rate is high, voids tend to remain in the obtained ferrite layer due to the unevenness of the particle surface. When SF-2 is within the above-mentioned range, a dense ferrite layer can be obtained at a high film forming rate. SF-2 is determined according to the following formula (1).

$$SF-2 = \left( \left( \frac{(\text{PROJECTED PERIPHERAL LENGTH OF PARTICLE})^2}{(\text{PROJECTED AREA OF PARTICLE})} \right) \div 4\pi \right) \\ \cdots (1)$$

An average value of an aspect ratio of the ferrite powder is preferably 1.00 or more and 2.00 or less, more preferably 1.02 or more and 1.75 or less, and still more preferably 1.02 or more and 1.50 or less. When the aspect ratio is within the above-mentioned range, a gas flow for supplying the raw material is stabilized during film formation. On the other hand, when the aspect ratio exceeds the above-mentioned range, the raw material is easily clogged in a pipe from a raw material supply container to a nozzle. Therefore, the film forming rate may become unstable with the elapse of a film forming time. The aspect ratio is obtained according to the following formula (2).

$$\text{ASPECT RATIO} = \frac{\text{MAJOR AXIS FERET DIAMETER}}{\text{MINOR AXIS FERET DIAMETER}} \cdots (2)$$

Further, a CV value of the particle diameter of the ferrite powder is preferably 0.5 or more and 2.5 or less. Here, the CV value indicates a degree of variation in the particle diameter of the particles in the powder, and the CV value decreases as the particle diameter becomes more uniform, and increases as the particle diameter becomes more non-uniform. In a common pulverization method (bead mill, jet mill, or the like) for obtaining irregular particles, it is difficult to obtain powder less than 0.5. On the other hand, powder of more than 2.5 is easily clogged in the pipe from the raw material supply container to the nozzle. Therefore, the film forming rate may become unstable with the elapse of a film forming time. The CV value is obtained according to the following formula (3) using a 10% cumulative diameter (D10), a 50% cumulative diameter (D50; average particle diameter), and a 90% cumulative diameter (D90) in volume particle size distribution.

$$\text{CV VALUE} = \frac{D90 - D10}{D50} \cdots (3)$$

In a case where the calcination is performed at the time of preparing the ferrite powder, for example, the calcination may be performed under a condition of 500°C to 1,100°C × 1 hour to 24 hours in an air atmosphere. In addition, in a case where the sintering is to be performed, the sintering may be performed, for example, under a condition of 800°C to 1,350°C × 4 hours to 24 hours in an atmosphere such as the air or a reducing atmosphere. In addition, the oxygen concentration at the time of the sintering is preferably low. The reason is that this allows a lattice defect to be intentionally generated in a spinel crystal of the ferrite powder. When the lattice defect is contained in the crystal, plastic deformation tends to occur from the lattice defect as a starting point when the raw material grains collide with the base material in the subsequent film forming process. Therefore, a dense ferrite layer having high adhesion can be easily obtained. The oxygen concentration is preferably 0.001 vol% to 10 vol%, more preferably 0.001 vol% to 5 vol%, and still more preferably 0.001 vol% to 2 vol%. Further, when the ferrite contains copper (Cu), it is preferable to perform the sintering under a reducing atmosphere. When the sintering is performed in a reducing atmosphere, copper oxide (II) (CuO) releases a part of oxygen atoms and changes to copper oxide (I) ($Cu_2O$). In this case, a lattice defect is easily generated. In addition, making the ferrite powder to have an iron (Fe)-rich composition is also effective for obtaining a dense ferrite layer.

Pulverization of the sintered product is preferably performed using a pulverizer such as a dry bead mill. By performing dry pulverization, the sintered product is subjected to a mechanochemical treatment, the crystallite diameter is reduced, and surface activity is increased. Pulverized powder having high surface activity contributes to densification of the ferrite layer obtained in the subsequent film forming process, along with an effect of an appropriate particle diameter. The crystallite diameter (CSp) of the ferrite powder is preferably 10 Å or more and 50 Å or less. By using ferrite powder having a fine crystallite diameter, a dense ferrite layer can be obtained.

<Film Forming Process>

In the film forming process (deposition process), the ferrite powder is formed into a film on the surface of the resin base material by the aerosol deposition method (AD method). The aerosol deposition method (AD method) is a method in which aerosolized raw material fine particles are injected onto a substrate at a high speed to form a coating film by a room temperature impact solidification phenomenon. Since the room temperature impact solidification phenomenon is utilized, a dense film having high adhesion can be formed. In addition, since the fine particles are used as a supply raw material, a thick film can be obtained at a high film forming rate as compared with the thin film forming method such as a sputtering method or a vapor deposition method in which the raw material is separated to an atomic level. Further, since the film can be formed at room temperature, it is not necessary to complicate a configuration of a device, and an effect of reducing manufacturing cost can also be obtained.

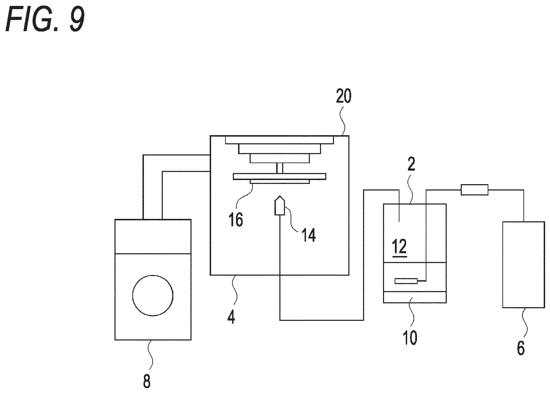

Fig. 9 illustrates an example of a configuration of an aerosol deposition film forming device. An aerosol deposition film forming device (20) includes an aerosolization chamber (2), a film formation chamber (4), a conveying gas source (6), and a vacuum evacuation system (8). The aerosolization chamber (2) includes a vibrator (10) and a raw material container (12) disposed thereon. A nozzle (14) and a stage (16) are provided inside the film formation chamber (4). The stage (16) is implemented to be movable perpendicularly to an injection direction of the nozzle (14).

In the film formation, a conveying gas is introduced from the conveying gas source (6) into the raw material container (12), and the vibrator (10) is caused to operate. Raw material fine particles (ferrite powder) are charged into the raw material container (12). The raw material fine particles are mixed with the conveying gas by vibration and subjected to aerosolization. In addition, the film formation chamber (4) is evacuated by the vacuum evacuation system (8) to depressurize the chamber. The aerosolized raw material fine particles are conveyed into the film formation chamber (4) by a pressure difference, and are injected from the nozzle (14). The injected raw material fine particles collide with a surface of a substrate (base material) placed on the stage (16) and are deposited thereon. In this case, in the raw material fine particles accelerated by gas conveyance, kinetic energy is locally released at the time of collision with the substrate, and bonding between the substrate and the particles and bonding between the particles are realized. Therefore, a dense film can be formed. By moving the stage (16) during the film formation, it is possible to form a coating film having a spread in a plane direction.

The reason why a dense ferrite layer can be obtained by the manufacturing method of the present embodiment is presumed as follows. Thus, it is said that ceramic is usually a material having a high elastic limit and being hardly plastically deformed. However, it is considered that when the raw material fine particles collide with the substrate at a high speed during the film formation by an aerosol deposition method, a large impact force exceeding the elastic limit is generated, and thus the fine particles are plastically deformed. Specifically, defects such as crystal plane deviation and dislocation movement occur inside the fine particles, and in order to compensate for the defects, plastic deformation occurs and a crystal structure becomes fine. In addition, a newly generated surface is formed and movement of substances occurs. As a result of a combined effect of the above, it is considered that bonding forces between the substrate and the particles and between the particles are increased, and a dense film can be obtained. Further, it is considered that a part of ferrite is decomposed and reoxidized during the plastic deformation, and $\alpha$-$Fe_2O_3$ contributing to an increase in resistance is generated. In addition, it is also presumed that the fine particles colliding with the resin base material as a substrate in an initial stage of the film formation penetrate into the base material, and the penetrated fine particles develop an anchor effect, thereby increasing the adhesion between the ferrite layer and the base material.

In order to obtain a dense ferrite layer, the average particle diameter of the raw material ferrite powder is important. In the present embodiment, the average particle diameter (D50) of the ferrite powder is limited to 2.5 $\mu$m or more and 10.0 $\mu$m or less. When the average particle diameter is less than 2.5 $\mu$m, it is difficult to obtain a dense film. This is because powder having a small average particle diameter has a small mass of particles constituting the powder. The aerosolized raw material fine particles collide with the substrate at a high speed together with the conveying gas. The conveying gas colliding with the substrate changes its direction and flows as an exhaust gas. Particles having a small particle diameter and a small mass are washed away by an exhaust flow of the conveying gas, and a collision speed with the surface of the substrate and an impact force caused by the collision are reduced. When the impact force is small, the plastic deformation of the fine particles becomes insufficient, and the crystallite diameter is not reduced. The formed film does not become dense and becomes a compact in which the powder is only compressed. Such a compact includes a large number of voids therein, and is inferior in magnetic properties and electrical properties. In addition, the adhesion to the base material does not increase. On the other hand, when the average particle diameter is excessively large exceeding 10.0 $\mu$m, the impact force received by one particle is large, but the number of contact points between particles is reduced. Therefore, the plastic deformation and packing are insufficient, and it is difficult to obtain a dense film.

Film forming conditions according to the aerosol deposition method are not particularly limited as long as a dense ferrite layer having high adhesion can be obtained. Air or an inert gas (nitrogen, argon, helium, or the like) can be used as the conveying gas. However, atmosphere (air) that is easy to handle is preferable. A flow rate of the conveying gas may be, for example, 1.0 L/min to 20.0 L/min. In addition, an internal pressure of the film formation chamber may be, for example, 10 Pa to 50 Pa before the film formation and 50 Pa to 400 Pa in the middle of the film formation. A scanning speed (moving speed) of the resin base material (stage) may be, for example, 1.0 mm/s to 10.0 mm/s. Coating (film formation) may be performed only once or may be performed a plurality of times. However, from a viewpoint of sufficiently ensuring the film thickness of the ferrite layer to be obtained, it is preferable to perform the coating a plurality of times. The number of times of coating is, for example, 5 times or more and 100 times or less.

The ratio (LCf/LCp) of the lattice constant (LCf) of the spinel phase contained in the ferrite layer to the lattice constant (LCp) of the spinel phase contained in the raw material ferrite powder is preferably 0.95 or more and 1.05 or less ($0.95 \leq$ LCf/LCp $\leq 1.05$). The spinel phase in the raw material ferrite powder has an oxygen-deficient composition and easily contains lattice defects. Therefore, the lattice constant tends to be larger than that in a state where no lattice defect exists. On the other hand, when the raw material ferrite powder is subjected to an aerosol deposition film forming treatment, plastic deformation from the lattice defects as a starting point occurs. In addition, an active surface is generated due to the plastic deformation, and the active surface is oxidized. Since reconstruction of the crystal structure and reoxidation of the active surface occur, the lattice constant easily changes. By controlling the lattice constant ratio (LCf/LCp) within the above-mentioned range, an amount of $\alpha$-$Fe_2O_3$ accompanying the reconstruction of the crystal structure and the reoxidation of the active surface can be adjusted within a desired range, and as a result, a ferrite layer having excellent electrical properties (electric insulation) can be formed while maintaining excellent magnetic properties. The lattice constant ratio (LCf/LCp) is more preferably 0.99 or more and 1.04 or less.

A degree of change in the lattice constant varies depending on manufacturing conditions and a composition of the raw material ferrite powder as well as a material and a type of the base material. Specifically, when a ferrite composition is a stoichiometric composition or an iron (Fe)-rich composition ($M_xFe_{3-x}O_4$: $0 < x \leq 1$, and M is a metal atom), an amount of oxygen contained in the raw material ferrite powder is likely to be substantially smaller than a stoichiometric ratio, depending on sintering conditions thereof. Therefore, the lattice constant of the raw material ferrite powder tends to increase. On the other hand, in the ferrite layer formed by the AD method, the crystal structure is reconstructed by oxidation accompanying the plastic deformation of the raw material grains, and thus the lattice constant tends to be smaller than that of the raw material ferrite powder. In particular, this tendency is remarkable in a case where ferrite powder containing lithium (Li) or manganese (Mn) or ferrite powder sintered at a lower oxygen concentration than the air is used. Therefore, in this case, LCf/LCp is likely to be less than 1.00.

When an amount of Fe is smaller than the stoichiometric ratio of the ferrite ($M_xFe_{3-x}O_4$: $1 < x$, and M is a metal atom), the amount of oxygen contained in the ferrite is likely to be about the same as the stoichiometric ratio. In addition, in the ferrite layer formed by the aerosol deposition method, lattice defects due to the plastic deformation increase, and thus the lattice constant tends to increase. In particular, this tendency is remarkable in a case where ferrite powder containing copper (Cu) or ferrite powder sintered in the air atmosphere is used. Therefore, in this case, LCf/LCp tends to exceed 1.00.

The lattice constant ratio (LCf/LCp) can be adjusted by controlling conditions of the aerosol deposition film formation. Thus, progress of strain and reoxidation can be promoted by increasing the collision speed of the raw material fine particles. The collision speed of the raw material fine particles can be changed by adjusting the internal pressure of the chamber or the like. In addition, excessive progress of reoxidation can be prevented by changing the film forming rate. This is because the reoxidation proceeds from the surface of the raw material fine particles, and thus the progress of the reoxidation is prevented when the film forming rate of the ferrite layer is increased to shorten an exposure time of the raw material fine particles to the air.

A ratio (CSf/CSp) of a crystallite diameter (CSf) of the spinel phase contained in the ferrite layer to a crystallite diameter (CSp) of the spinel phase contained in the raw material ferrite powder is preferably 0.01 or more and 0.50 or less ($0.01 \leq$ CSf/CSp $\leq 0.50$). The crystallite diameter of the ferrite changes through the aerosol deposition film formation. This is because strain occurs at the time of collision with the base material, and the active surface is reoxidized. Even when the film formation is performed under a condition that the crystallite diameter ratio (CSf/CSp) becomes excessively small, a dense ferrite layer having high adhesion cannot be obtained. This is because the internal stress of the ferrite layer becomes too large. In addition, even when the film formation could be performed, the ferrite layer is easily peeled off due to the internal stress. Therefore, stability over time is insufficient. The crystallite diameter ratio (CSf/CSp) is more preferably 0.05 or more and 0.30 or less, and still more preferably 0.10 or more and 0.20 or less.

In this way, the magnetic composite of the present embodiment can be obtained. In the obtained magnetic composite, since the ferrite layer is dense, the magnetic properties and the electrical properties (electric insulation) thereof are excellent. In addition, the adhesion to the resin base material is high. Actually, the present inventors succeeded in preparing a magnetic composite including a ferrite layer having a relative density of 0.95 or more and adhesion of 8H in pencil hardness. Further, the ferrite layer has relatively small magnetic loss in a high-frequency region. In addition, although not limited, a magnetic composite including a thinned resin base material has flexibility, and thus a device having a complicated shape can be prepared. The magnetic composite including such a ferrite layer can be used not only for an electromagnetic wave absorber but also for an application of an electronic component such as a transformer, an inductance element, and an impedance element, and is particularly suitable for a UHF tag, a 5G filter, and a high-frequency inductor.

A technique for preparing such a magnetic composite of the present embodiment has not been known so far as the inventors know. For example, regarding the ferrite thin film proposed in Patent Literature 1, it is difficult to form the ferrite thin film to be thick in view of manufacture. Actually, Patent Literature 1 discloses that Mn-Zn ferrite is formed on a polyethylene terephthalate film by a counter target type magnetron sputtering method, but the film thickness of the ferrite layer is only 3 nm (paragraph [0030]). In addition, in Patent Literature 2, ferrite fine particles having a submicron particle diameter are used as a raw material (paragraph [0036]), and it is difficult to form a dense ferrite film having high adhesion with such a fine raw material. Patent Literature 3 discloses that a radio wave absorber is prepared using the AD method (paragraphs [0020] to [0021]), but does not disclose the particle diameter of raw material ferrite particles, and details of properties other than radio wave absorption properties of the obtained ferrite layer are unclear (paragraphs [0020] to [0022]).

EXAMPLES

The present invention will be described in more detail using the following examples. However, the present invention is not limited to the following examples.

(1) Preparation of Magnetic Composite

[Example 1]

In Example 1, ferrite powder containing Mn-Zn ferrite as a principal component was prepared, and the obtained ferrite powder was formed into a film on a polycarbonate (PC) plate (resin base material) to prepare a magnetic composite. Preparation of the ferrite powder and film formation were performed by the following procedures.

<Preparation of Ferrite Powder>

As raw materials, iron oxide ($Fe_2O_3$), trimanganese tetraoxide ($Mn_3O_4$), and zinc oxide (ZnO) were used, and the raw materials were weighed and mixed such that a molar ratio of $Fe_2O_3$:$Mn_3O_4$:ZnO = 53:12.3:10. The mixing was performed using a Henschel mixer. The obtained mixture was molded using a roller compactor to obtain a granulated product (temporary granulated product).

Next, the granulated raw material mixture (temporary granulated product) was calcined to prepare a calcined product. The calcination was performed using a rotary kiln under a condition of 880°C × 2 hours in an air atmosphere.

Thereafter, the obtained calcined product was pulverized and granulated to prepare a granulated product. First, the calcined product was coarsely pulverized using a dry bead mill (steel beads of φ3/16 inches), and then water was added thereto, followed by fine pulverization using a wet bead mill (zirconia beads of φ0.65 mm) to obtain a slurry. A solid content concentration of the obtained slurry was 50 mass%, and a particle diameter (slurry particle diameter) of the pulverized powder was 2.15 μm. To the obtained slurry, a polycarboxylic acid ammonium salt was added as a dispersant at a ratio of 50 cc with respect to 25 kg of a solid content in the slurry, and a 10 mass% aqueous solution of polyvinyl alcohol (PVA) was added as a binder at an addition amount of 500 cc. Thereafter, the slurry to which the dispersant and the binder were added was granulated using a spray dryer to obtain the granulated product.

Then, the obtained granulated product was sintered under a condition of 1,250°C × 4 hours in a non-oxidizing atmosphere using an electric furnace to prepare a sintered product. Next, the obtained sintered product was pulverized using the dry bead mill (steel beads of φ3/16 inches) to obtain a pulverized sintered product.

<Film Formation>

A ferrite layer was formed on a surface of a resin base material using the obtained pulverized sintered product. A polycarbonate (PC) plate having a thickness of 500 μm was used as the resin base material. The PC plate was colorless and transparent. The film formation was performed by the aerosol deposition method (AD method) under the following conditions.
- Carrier gas (conveying gas): air
- Gas flow rate: 5.0 L/min
- Internal pressure of film formation chamber (before film formation): 30 Pa
- Internal pressure of film formation chamber (during film formation): 120 Pa
- Substrate scanning speed: 5 mm/sec
- Number of times of coating: 10 times
- Distance from base material to nozzle: 20 mm
- Nozzle shape: 10 mm $\times$ 0.4 mm

[Example 2]

In Example 2, the number of times of coating during film formation was changed from 10 times to 20 times. A magnetic composite was prepared in the same manner as in Example 1 except for the above.

[Example 3]

In Example 3, a polyimide (PI) film having a thickness of 50 $\mu$m was used as the resin base material. The PI film was brown and transparent. A magnetic composite was prepared in the same manner as in Example 1 except for the above.

[Example 4]

In Example 4, a polyvinyl chloride (PVC) plate having a thickness of 500 $\mu$m was used as the resin base material. The PVC plate was colorless and transparent. A magnetic composite was prepared in the same manner as in Example 1 except for the above.

[Example 5]

In Example 5, a polyoxymethylene (POM) plate having a thickness of 500 $\mu$m was used as the resin base material. The POM plate was white and opaque. A magnetic composite was prepared in the same manner as in Example 1 except for the above.

[Example 6]

In Example 6, an acrylonitrile-butadiene-styrene (ABS) plate having a thickness of 500 $\mu$m was used as the resin base material. The ABS plate was milky white and opaque. A magnetic composite was prepared in the same manner as in Example 1 except for the above.

[Example 7]

In Example 7, a polyetheretherketone (PEEK) plate having a thickness of 5,000 $\mu$m was used as the resin base material. The PEEK plate was gray and opaque. A magnetic composite was prepared in the same manner as in Example 1 except for the above.

[Example 8]

In Example 8, a polyamide (PA) plate having a thickness of 5,000 $\mu$m was used as the resin base material. The PA plate was blue and opaque. A magnetic composite was prepared in the same manner as in Example 1 except for the above.

[Example 9 (Comparative Example)]

In Example 9, a polypropylene (PP) plate having a thickness of 500 $\mu$m was used as the resin base material. The PP plate was white and translucent. A magnetic composite was prepared in the same manner as in Example 1 except for the above.

[Example 10 (Comparative Example)]

In Example 10, a polymethyl methacrylate (PMMA) plate having a thickness of 500 $\mu$m was used as the resin base material. The PMMA plate was colorless and transparent. A magnetic composite was prepared in the same manner as in Example 1 except for the above.

[Example 11]

In Example 11, raw material grains (ferrite powder) containing Ni-Cu-Zn ferrite as a principal component were prepared, and then the obtained ferrite powder was formed into a film on a polycarbonate (PC) plate to prepare a magnetic composite. Preparation of the ferrite powder and film formation were performed by the following procedures.

<Preparation of Ferrite Powder>

As raw materials, iron oxide ($Fe_2O_3$), zinc oxide (ZnO), nickel oxide (NiO), and copper oxide (CuO) were used, and the raw materials were weighed and mixed such that a molar ratio of $Fe_2O_3$:ZnO:NiO:CuO = 48.5:33:12.5:6. A Henschel mixer was used for the mixing. The obtained mixture was molded using a roller compactor to obtain a granulated product (temporary granulated product).

Next, the granulated raw material mixture (temporary granulated product) was calcined to prepare a calcined product. The calcination was performed using a rotary kiln under a condition of 910°C $\times$ 2 hours in an air atmosphere.

Thereafter, the obtained calcined product was pulverized and granulated to prepare a granulated product. First, the calcined product was coarsely pulverized using a dry bead mill (steel beads of (p3/16 inches), and then water was added thereto, followed by fine pulverization using a wet bead mill (zirconia beads of $\varphi$0.65 mm) to obtain a slurry. A solid content concentration of the obtained slurry was 50 mass%, and a particle diameter (slurry particle diameter) of the pulverized powder was 2.77 $\mu$m. To the obtained slurry, a polycarboxylic acid ammonium salt was added as a dispersant at a ratio of 50 cc with respect to 25 kg of a solid content in the slurry, and a 10 mass% aqueous solution of polyvinyl alcohol (PVA) was added as a binder at an addition amount of 250 cc. Thereafter, the slurry to which the dispersant and the binder were added was granulated using a spray dryer to obtain the granulated product.

Then, the granulated product was sintered under a condition of 1,100°C $\times$ 4 hours in an oxidizing atmosphere using an electric furnace to prepare a sintered product. Next, the obtained sintered product was pulverized using the dry bead mill (steel beads of $\varphi$3/16 inches) to obtain a pulverized sintered product.

<Film Formation>

A ferrite layer was formed on a surface of a resin base material using the obtained pulverized sintered product. A polycarbonate (PC) plate having a thickness of 500 $\mu$m was used as the resin base material. The film formation was performed in the same manner as in Example 1.

[Example 12 (Comparative Example)]

In Example 12, a fine pulverized sintered product was obtained by changing treatment conditions when the sintered product was subjected to a dry bead mill treatment. A magnetic composite was prepared in the same manner as in Example 11 except for the above.

[Example 13 (Comparative Example)]

In Example 13, a fine pulverized sintered product was obtained by changing treatment conditions when the sintered product was subjected to a dry bead mill treatment. A magnetic composite was prepared in the same manner as in Example 1 except for the above.

[Example 14 (Comparative Example)]

In Example 14, the number of times of coating during film formation was changed from 10 times to once. A magnetic composite was prepared in the same manner as in Example 1 except for the above.

[Example 15 (Comparative Example)]

In Example 15, a gas flow rate during film formation was changed from 5.0 L/min to 1.0 L/min. In addition, an internal pressure of the film formation chamber (during film formation) was changed from 120 Pa to 80 Pa. A magnetic composite was prepared in the same manner as in Example 1 except for the above.

[Example 16 (Comparative Example)]

In Example 16, a gas flow rate during film formation was changed from 5.0 L/min to 2.5 L/min. In addition, an internal pressure of the film formation chamber (during film formation) was changed from 120 Pa to 100 Pa. A magnetic composite was prepared in the same manner as in Example 1 except for the above.

[Examples 17 to 25]

Magnetic composites were prepared by changing manufacturing conditions of the magnetic composites as shown in Tables 1 and 2.
For Examples 1 to 25, manufacturing conditions of the ferrite powder and the magnetic composites are summarized in Table 1 and Table 2.

Table 1 Manufacture conditions for ferrite powder

| | Charged composition | | | | | | Calcination | | Final granulation | | | | Final sintering | |
|---|---|---|---|---|---|---|---|---|---|---|---|---|---|---|
| | Fe₂O₃ (mol) | Mn₃O₄ (mol) | MgO (mol) | ZnO (mol) | NiO (mol) | CuO (mol) | Temperature (°C) | Atmosphere | Slurry particle diameter (μm) | Amount of binder (cc) | Amount of dispersant (cc) | Slurry concentration (mass%) | Temperature (°C) | Atmosphere |
| Example 1 | 53 | 12.3 | - | 10 | - | - | 880 | Air | 2.15 | 500 | 50 | 50 | 1,250 | Non-oxidizing |
| Example 2 | 53 | 12.3 | - | 10 | - | - | 880 | Air | 2.15 | 500 | 50 | 50 | 1,250 | Non-oxidizing |
| Example 3 | 53 | 12.3 | - | 10 | - | - | 880 | Air | 2.15 | 500 | 50 | 50 | 1,250 | Non-oxidizing |
| Example 4 | 53 | 12.3 | - | 10 | - | - | 880 | Air | 2.15 | 500 | 50 | 50 | 1,250 | Non-oxidizing |
| Example 5 | 53 | 12.3 | - | 10 | - | - | 880 | Air | 2.15 | 500 | 50 | 50 | 1,250 | Non-oxidizing |
| Example 6 | 53 | 12.3 | - | 10 | - | - | 880 | Air | 2.15 | 500 | 50 | 50 | 1,250 | Non-oxidizing |
| Example 7 | 53 | 12.3 | - | 10 | - | - | 880 | Air | 2.15 | 500 | 50 | 50 | 1,250 | Non-oxidizing |
| Example 8 | 53 | 12.3 | - | 10 | - | - | 880 | Air | 2.15 | 500 | 50 | 50 | 1,250 | Non-oxidizing |
| Example 9* | 53 | 12.3 | - | 10 | - | - | 880 | Air | 2.15 | 500 | 50 | 50 | 1,250 | Non-oxidizing |
| Example 10* | 53 | 12.3 | - | 10 | - | - | 880 | Air | 2.15 | 500 | 50 | 50 | 1,250 | Non-oxidizing |
| Example 11 | 48.5 | - | - | 33 | 12.5 | 6 | 910 | Air | 2.77 | 250 | 50 | 50 | 1,100 | Oxidizing |
| Example 12* | 48.5 | - | - | 33 | 12.5 | 6 | 910 | Air | 2.77 | 250 | 50 | 50 | 1,100 | Oxidizing |
| Example 13* | 53 | 12.3 | - | 10 | - | - | 880 | Air | 2.15 | 500 | 50 | 50 | 1,250 | Non-oxidizing |

(continued)

| | Charged composition | | | | | | Calcination | | Final granulation | | | | Final sintering | |
|---|---|---|---|---|---|---|---|---|---|---|---|---|---|---|
| | Fe$_2$O$_3$ (mol) | Mn$_3$O$_4$ (mol) | MgO (mol) | ZnO (mol) | NiO (mol) | CuO (mol) | Temperature (°C) | Atmosphere | Slurry particle diameter (μm) | Amount of binder (cc) | Amount of dispersant (cc) | Slurry concentration (mass%) | Temperature (°C) | Atmosphere |
| Example 14* | 53 | 12.3 | - | 10 | - | - | 880 | Air | 2.15 | 500 | 50 | 50 | 1,250 | Non-oxidizing |
| Example 15* | 53 | 12.3 | - | 10 | - | - | 880 | Air | 2.15 | 500 | 50 | 50 | 1,250 | Non-oxidizing |
| Example 16* | 53 | 12.3 | - | 10 | - | - | 880 | Air | 2.15 | 500 | 50 | 50 | 1,250 | Non-oxidizing |
| Example 17 | 53 | 12.3 | - | 10 | - | - | 880 | Air | 2.15 | 500 | 50 | 50 | 1,250 | Non-oxidizing |
| Example 18 | 51.5 | 9.3 | - | 20.5 | - | - | 880 | Air | 2.22 | 500 | 50 | 50 | 1,250 | Non-oxidizing |
| Example 19 | 52 | 8 | - | 24 | - | - | 880 | Air | 2.42 | 500 | 50 | 50 | 1,250 | Non-oxidizing |
| Example 20 | 48.5 | - | - | 29.25 | 16 | 6.25 | 850 | Air | 2.56 | 500 | 50 | 50 | 1,100 | Oxidizing |
| Example 21 | 48.5 | - | - | 33 | 12.5 | 6 | 910 | Air | 2.77 | 250 | 50 | 50 | 1,100 | Oxidizing |
| Example 22 | 48 | - | - | 32.5 | 19.5 | - | 950 | Air | 2.61 | 500 | 50 | 50 | 1,250 | Oxidizing |
| Example 23 | 50.1 | 13.3 | 10 | - | - | - | 920 | Air | 2.13 | 500 | 50 | 50 | 1,180 | Non-oxidizing |
| Example 24 | 80.7 | - | - | 19.3 | - | - | 880 | Non-oxidizing | 2.45 | 1,000 | 50 | 50 | 1,300 | Non-oxidizing |
| Example 25 | 85.7 | - | - | 14.3 | - | - | 880 | Non-oxidizing | 2.52 | 1,000 | 50 | 50 | 1,300 | Non-oxidizing |

Note 1) "*" indicates a comparative example.

Table 2 Manufacture conditions for magnetic composite

| | Aerosol deposition film formation | | | | | | |
|---|---|---|---|---|---|---|---|
| | Carrier gas | Gas flow rate (L/min) | Internal pressure of film formation chamber (Pa) | | Substrate scanning speed (mm/sec) | Number of times of coating | |
| | | | Before film formation | During film formation | | Surface | Back surface |
| Example 1 | Air | 5.0 | 30 | 120 | 5 | 10 | - |
| Example 2 | Air | 5.0 | 30 | 120 | 5 | 20 | - |
| Example 3 | Air | 5.0 | 30 | 120 | 5 | 10 | - |
| Example 4 | Air | 5.0 | 30 | 120 | 5 | 10 | - |
| Example 5 | Air | 5.0 | 30 | 120 | 5 | 10 | - |
| Example 6 | Air | 5.0 | 30 | 120 | 5 | 10 | - |
| Example 7 | Air | 5.0 | 30 | 120 | 5 | 10 | - |
| Example 8 | Air | 5.0 | 30 | 120 | 5 | 10 | - |
| Example 9* | Air | 5.0 | 30 | 120 | 5 | 10 | - |
| Example 10* | Air | 5.0 | 30 | 120 | 5 | 10 | - |
| Example 11 | Air | 5.0 | 30 | 120 | 5 | 10 | - |
| Example 12* | Air | 5.0 | 30 | 120 | 5 | 10 | - |
| Example 13* | Air | 5.0 | 30 | 120 | 5 | 10 | - |
| Example 14* | Air | 5.0 | 30 | 120 | 5 | 1 | - |
| Example 15* | Air | 1.0 | 30 | 80 | 5 | 10 | - |
| Example 16* | Air | 2.5 | 30 | 100 | 5 | 10 | - |
| Example 17 | Air | 2.5 | 30 | 100 | 5 | 10 | 10 |
| Example 18 | Air | 2.5 | 30 | 100 | 5 | 10 | 10 |
| Example 19 | Air | 2.5 | 30 | 100 | 5 | 10 | 10 |
| Example 20 | Air | 2.5 | 30 | 100 | 5 | 10 | 10 |
| Example 21 | Air | 2.5 | 30 | 100 | 5 | 10 | 10 |
| Example 22 | Air | 2.5 | 30 | 100 | 5 | 10 | 10 |
| Example 23 | Air | 2.5 | 30 | 100 | 5 | 10 | 10 |

(continued)

| | Aerosol deposition film formation | | | | | | |
|---|---|---|---|---|---|---|---|
| | Carrier gas | Gas flow rate (L/min) | Internal pressure of film formation chamber (Pa) | | Substrate scanning speed (mm/sec) | Number of times of coating | |
| | | | Before film formation | During film formation | | Surface | Back surface |
| Example 24 | Air | 2.5 | 30 | 100 | 5 | 10 | 10 |
| Example 25 | Air | 2.5 | 30 | 100 | 5 | 10 | 10 |
| Note 1) "*" indicates a comparative example. | | | | | | | |

(2) Evaluation

Evaluations on various properties of the ferrite powder, the resin base material, and the magnetic composite in Examples 1 to 25 were made as follows.

<Particle Shape (Raw Material Powder)>

An average value of SF-2 and an average value of the aspect ratio of the ferrite powder were determined as follows. The ferrite powder was analyzed by using a particle image analyzer (Morphologi G3, manufactured by Spectris Plc.), and a projected peripheral length, a projected area, a major axis Feret diameter, and a minor axis Feret diameter were determined for 30,000 particles. The analysis was performed using an objective lens with a magnification of 20 times. Then, obtained data was used to calculate SF-2 and the aspect ratio for each particle according to the following formulae (1) and (2), and average values thereof were obtained.

$$SF\text{-}2 = \left( \left( \frac{(\text{PROJECTED PERIPHERAL LENGTH OF PARTICLE})^2}{(\text{PROJECTED AREA OF PARTICLE})} \right) \div 4\pi \right) \quad \cdots (1)$$

$$\text{ASPECT RATIO} = \frac{\text{MAJOR AXIS FERET DIAMETER}}{\text{MINOR AXIS FERET DIAMETER}} \quad \cdots (2)$$

<Particle Size Distribution (Raw Material Grain)>

The particle size distribution of the ferrite powder was measured as follows. First, 0.1 g of a sample and 20 ml of water were placed in a 30 ml beaker, and two drops of sodium hexametaphosphate were added as a dispersant. Next, the mixture was dispersed using an ultrasonic homogenizer (model UH-150, manufactured by SMT Co., Ltd.). In this case, an output level of the ultrasonic homogenizer was set to 4, and dispersion was performed for 20 seconds. Thereafter, bubbles generated on a surface of the beaker were removed, and the beaker was introduced into a laser diffraction type particle size distribution measuring device (SALD-7500nano, manufactured by Shimadzu Corporation) to perform the measurement. In this measurement, a 10% cumulative diameter (D10), a 50% cumulative diameter (D50; average particle diameter), and a 90% cumulative diameter (D90) in the volume particle size distribution were obtained. Measurement conditions were set to a pump speed of 7, an internal ultrasonic irradiation time of 30, and a refractive index of 1.70-050i. Then, D10, D50, and D90 were used to calculate a CV value according to the following formula (3).

$$\text{CV VALUE} = \frac{D90 - D10}{D50} \quad \cdots (3)$$

<XRD (Raw Material Powder and Ferrite Layer)>

The ferrite powder and the ferrite layer of the magnetic composite were analyzed by an X-ray diffraction (XRD) method. Analysis conditions were as follows.

- X-ray diffraction device: X'pertNTD (including a high-speed detector) manufactured by PANalytical
- Radiation source: Co-K$\alpha$
- Tube voltage: 45 kV
- Tube current: 40 mA
- Scanning speed: 0.002°/s (continuous scanning)
- Scanning range (2$\theta$): 15° to 90°

In an obtained X-ray diffraction profile, an integrated intensity ($I_{222}$) of a (222) plane diffraction peak of a spinel phase and an integrated intensity ($I_{311}$) of a (311) plane diffraction peak were obtained, and an XRD peak intensity ratio ($I_{222}/I_{311}$) was calculated. In addition, based on the X-ray diffraction profile, respective content ratios of the spinel phase and $\alpha$-Fe$_2$O$_3$ were obtained.

Further, the X-ray diffraction profile was subjected to Rietveld analysis to estimate lattice constants (LCp and LCf) of the spinel phase, and crystallite diameters (CSp and CSf) of the spinel phase were obtained according to Scherrer's formula. Then, a lattice constant change rate (LCf/LCp) and a crystallite diameter change rate (CSf/CSp) of the spinel phase before and after the film formation were calculated.

<Magnetic Properties (Raw Material Grain and Magnetic Composite)>

The magnetic properties (saturation magnetization, residual magnetization, and coercivity) of the ferrite powder and the magnetic composite were measured as follows. First, the sample was packed in a cell having an inner diameter of 6 mm and a height of 2 mm, and set in a sample vibrating type magnetic measurement device (VSM-C7-10A, manufactured by Toei Industry Co., Ltd.). An applied magnetic field was applied and swept to 5 kOe, and then the applied magnetic field was decreased to draw a hysteresis curve. Based on data of the obtained curve, the saturation magnetization (as), the residual magnetization ($\sigma$r), and the coercivity (He) of the sample were obtained.

When the thickness of the magnetic composite including the ferrite layer was 2 mm or less, the magnetic composite was processed into a disk shape having an outer diameter of 6 mm, and then the magnetic composite after the processing was packed in a cell and measured. When the thickness of the magnetic composite including the ferrite layer was more than 2 mm, a surface (resin surface) of the magnetic composite on which the ferrite layer was not formed was ground and processed to have a thickness of 500 $\mu$m, the magnetic composite was further punched into a disk shape having an outer diameter of 6 mm, and the punched magnetic composite was packed in a cell and measured.

<True Specific Gravity (Raw Material Grain)>

The true specific gravity of the raw material grain was measured by a gas substitution method in accordance with JIS Z8837:2018.

<Thickness and Element Distribution (Ferrite Layer)>

A cross section of the ferrite layer was observed using a field emission type scanning electron microscope (FE-SEM) to determine the thickness. Then, element mapping analysis for the cross section was performed using an energy dispersive X-ray spectrometer (EDX) attached to the microscope, and a mapping image was obtained.

<Density (Ferrite Layer)>

The density of the ferrite layer was measured as follows. First, a mass of a resin base material alone before the film of the ferrite layer is formed was measured. Next, a mass of the resin base material after the film of the ferrite layer was formed was measured, and a difference from the mass of the resin base material alone was calculated to obtain a mass of the ferrite layer. In addition, a film formation area and a film thickness of the ferrite layer were measured. The film thickness was determined by observing the cross section of the ferrite layer with a scanning electron microscope (SEM). Then, the density of the ferrite layer was calculated according to the following formula (4).

$$\text{DENSITY OF FERRITE LAYER} \left( g/cm^3 \right)$$

$$= \frac{\text{MASS OF FERRITE LAYER} (g)}{\text{FILM FORMATION AREA OF FERRITE LAYER} \left( cm^2 \right) \times \text{THICKNESS} (cm)}$$

$$\cdots (4)$$

<Surface Roughness (Resin Base Material and Ferrite Layer)>

An arithmetic mean height (Sa) and a maximum height (Sz) of the surface of each of the resin base material and the ferrite layer were evaluated using a laser microscope (OPTELICS HYBRID, manufactured by Lasertec Corporation). For each sample, measurement was performed at 10 points, and an average value thereof was obtained. The measurement was performed in accordance with JIS B 0601-2001. In addition, a roughness ratio (Sa/$d_F$) was calculated based on the arithmetic mean height (Sa) and the thickness ($d_F$) of the ferrite layer.

<Surface Resistance (Resin Base Material and Ferrite Layer)>

The surface resistance of the ferrite layer was measured using a resistivity meter (LorestaHP MCP-T410, manufactured by Mitsubishi Chemical Corporation). For each sample, measurement was performed at 10 points, and an average value thereof was obtained.

<Permeability (Magnetic Composite)>

The permeability of the magnetic composite was measured by a microstripline complex permeability measuring method using a vector network analyzer (PNA N5222B, 10 MHz to 26.5 GHz, manufactured by Keysight) and a permeability measuring device (manufactured by KEYCOM Corporation). Specifically, the magnetic composite was cut out and was set in the permeability measuring device as a measurement sample. Next, sweeping of a measurement frequency in a range of 100 MHz to 10 GHz was performed on a logarithmic scale. A real part $\mu'$ and an imaginary part $\mu''$ of complex permeability at a frequency of 1 GHz were determined, and a loss factor ($\tan\delta$) was calculated according to the following formula (5).

$$\tan\delta = \frac{\mu''}{\mu'} \quad \cdots \quad (5)$$

When the thickness of the magnetic composite including the ferrite layer was 1 mm or less, the magnetic composite was processed into a strip shape having a width of 5 mm and a length of 10 mm, and the magnetic composite after the processing was set in a measurement instrument for measurement. When the thickness of the magnetic composite including the ferrite layer was more than 1 mm, a resin surface of the magnetic composite on which the ferrite layer was not formed was ground and processed to have a thickness of 500 $\mu$m, the magnetic composite was further processed into a strip shape having a width of 5 mm and a length of 10 mm, and the processed magnetic composite was set in the measurement instrument for measurement.

<Bendability (Magnetic Composite)>

The magnetic composite (base material thickness of 50 $\mu$m) was wound around an inch tube to evaluate the bendability. Specifically, three types of inch tubes including a tube having an outer diameter of 1/16 inches, a tube having an outer diameter of 1/8 inches, and a tube having an outer diameter of 1/4 inches were prepared, and the magnetic composite was wound around each of the inch tubes such that the ferrite layer was on an outer side. Then, a state of the ferrite layer was visually observed, and rated as o to × according to the following criteria.
○: No change was observed in the ferrite layer before and after winding.
△: Cracks occurred in the ferrite layer after winding.
×: The ferrite layer was peeled off after winding.

<Adhesion (Magnetic Composite)>

The adhesion between the ferrite layer and the resin base material was evaluated by a pencil hardness test (pencil scratch test). The measurement was performed in accordance with old JIS K5400. In each test, scratching with a pencil having the same concentration mark was repeated five times. In this case, a tip of a pencil lead was polished every time the pencil was scratched. Pencil hardness increases in the order of 3B, 2B, B, HB, F, H, 2H, 3H, 4H, 5H, 6H, 7H, 8H, 9H, and 10H, and a higher hardness means better adhesion.

<Adhesion (Magnetic Composite)>

The adhesion between the ferrite layer and the resin base material of the magnetic composite (base material thickness of 500 $\mu$m and 5,000 $\mu$m) was evaluated by a cross cut method. The measurement was performed in accordance with JIS K5600-5-6:1999. Based on the obtained evaluation results, the samples were rated according to the following criteria.

A: An edge of a cut is completely smooth, and no peeling occurs in any mesh of a grid.
B: Slight peeling of a coating film occurs at an intersection of cuts. The number of portions affected by a cross-cut portion does not clearly exceed 5%.
C: The coating film is peeled off along the edge of the cut and/or at the intersection. The number of portions affected by the cross-cut portion clearly exceeds 5%, but does not exceed 15%.
D: The coating film is largely peeled peeled off partially or entirely along the edge of the cut, and/or various portions of a mesh are peeled off partially or entirely. The number of portions affected by the cross-cut portion clearly exceeds 15%, but does not exceed 35%.
E: The coating film is largely peeled off partially or entirely along the edge of the cut, and/or several meshes are peeled off partially or entirely. The number of portions affected by the cross-cut portion does not clearly exceed 65%.
F: A degree of peeling that cannot be classified into A to E.

(3) Evaluation Results

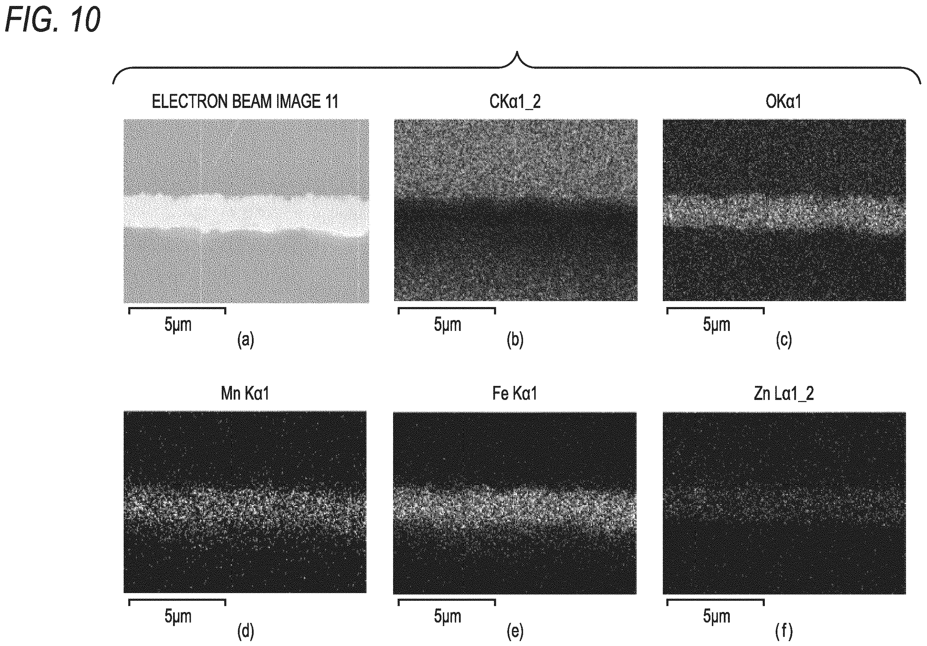

For Examples 1 to 25, properties of the ferrite powder and properties of the resin base material are shown in Tables 3 and 4, respectively. In addition, properties of the magnetic composite are shown in Tables 5 and 6.
As shown in Table 3, in all of the ferrite powder used for the film formations in Examples 1 to 11 and Examples 14 to 25, the content ratio of the spinel phase was as high as 99 mass% or more, and synthesis of the spinel-type ferrite sufficiently progressed. In addition, the XRD peak intensity ratio ($I_{222}/I_{311}$) was about 0.04 to 0.05, which was comparable to that of a common spinel-type ferrite. Further, the average particle diameter (D50) was 3.6 $\mu$m to 5.2 $\mu$m, and the crystallite diameter was about 10 nm to 18 nm. On the other hand, in the ferrite powder of Examples 12 and 13, the content ratio of the spinel phase was as low as less than 96 mass%. In addition, the crystallite diameter was as small as about 2 nm to 5 nm, and the magnetic properties were inferior. It is considered that since pulverization conditions during the dry bead mill treatment were strengthened and atomization was performed, oxidation of the raw material progressed.
As shown in Tables 5 and 6, in the magnetic composites of Examples 1 to 8, 11, and 17 to 25, the thickness ($d_F$) of the ferrite layer was 2.0 $\mu$m or more, and the XRD peak intensity ratio ($I_{222}/I_{311}$) was zero (0). In addition, the amount of $\alpha$-$Fe_2O_3$ was about 0.5 mass% to 19.7 mass%, and the crystallite diameter was as small as less than 2.20 nm. Therefore, these samples had relatively high relative density and adhesion, and high surface resistance. In particular, in Examples 1, 4, 7, and 8, the relative density was very high as 90% or more, and results of adhesion tests were also very excellent as 5H or more in pencil hardness. In addition, for the magnetic composites of Examples 3 and 17 to 25, results of bendability tests were good.
On the other hand, in Example 9, since polypropylene having a low specific gravity was used as the base material, the adhesion to the base material was weak, and since a ferrite layer having a low density was formed, sufficient magnetic properties were not obtained. In addition, in Example 10, the resin base material was scraped off by the ferrite powder injected at a high speed during film formation, and the ferrite layer could not be formed. The reason is considered to be that compatibility between the resin (PMMA) constituting the base material and the ferrite powder was poor, and an anchor effect did not function appropriately. In addition, in Examples 12 to 16, although the ferrite layer was seen to be formed, the ferrite layer was immediately peeled off when rubbed with a finger. In particular, in Examples 12 to 15, a laminate of powder called a compact was formed, and a film was not formed. Therefore, in Examples 10 and 12 to 16, a non-uniform (uneven) film was formed, and measurement of various properties was not possible.
Cross-sectional element mapping images of the ferrite layer of the magnetic composite obtained in Example 1 are illustrated in (a) to (f) of Fig. 10. Here, (a) to (f) of Fig. 10 are an electron beam image (a), a carbon (C) mapping image (b), an oxygen (O) mapping image (c), a manganese (Mn) mapping image (d), an iron (Fe) mapping image (e), and a zinc (Zn) mapping image (f), respectively. In (a) to (f) of Fig. 10, the resin base material is illustrated on a lower side, and the ferrite layer is shown on an upper side.

Component elements of the resin base material and the ferrite layer were clearly separated. Thus, carbon (C) was present on a base material side, and manganese (Mn), iron (Fe), zinc (Zn), and oxygen (O) were present only on a ferrite layer side. Based on the above, it was found that diffusion of elements due to a reaction did not occur between the resin base material and the ferrite layer.

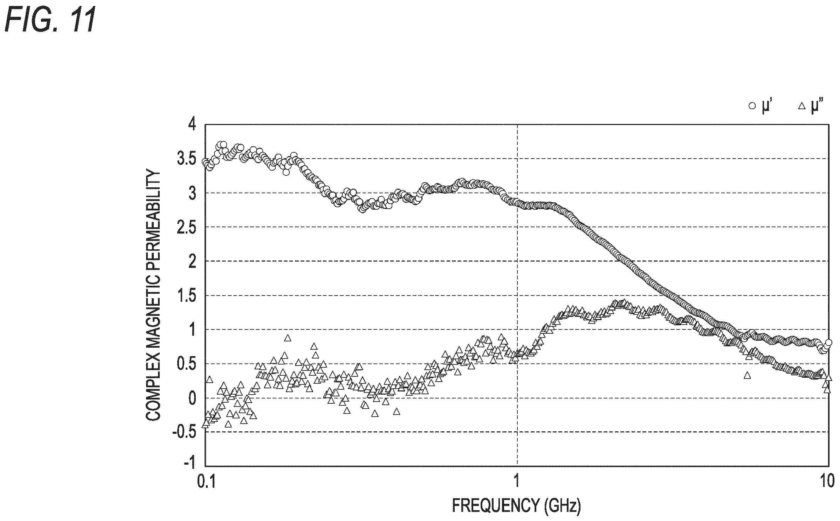

The permeability (real part $\mu'$ and imaginary part $\mu''$) of the magnetic composite obtained in Example 1 is illustrated in Fig. 11. From a low-frequency side over a high-frequency range of 1 GHz or more, it was found that $\mu''$ was substantially zero and $\mu'$ was a constant value, and $\mu''$ was a local maximum at a frequency of 1 GHz or more.

Based on these results, it was found that the magnetic composite of the present embodiment includes a ferrite layer that is dense, has a relatively large film thickness, is excellent in magnetic properties, and further has good adhesion.

Table 3 Properties of ferrite powder

| | Ferrite powder | | | | | | | | | | | | | |
|---|---|---|---|---|---|---|---|---|---|---|---|---|---|---|
| | Particle size distribution | | | SF-2 | Aspect ratio | True specific gravity (g/cm$^3$) | Crystal phase | | $I_{222}/I_{311}$ | Lattice constant LCp (A) | Crystallite diameter CSp (nm) | Magnetic properties (@5kOe) | | |
| | D10 (μm) | D50 (μm) | D90 (μm) | | | | Spinel phase (mass%) | α-Fe$_2$O$_3$ (mass%) | | | | σs (emu/g) | σr (emu/g) | Hc (Oe) |
| Example 1 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 2 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 3 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 4 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 5 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 6 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 7 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 8 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 9* | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 10* | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 11 | 0.9 | 4.5 | 11.5 | 1.22 | 1.43 | 5.54 | 99.6 | 0.4 | 0.046 | 8.4104 | 17.724 | 50.8 | 3.0 | 43.1 |
| Example 12* | 0.4 | 0.9 | 2.1 | 1.20 | 1.40 | 5.48 | 95.9 | 4.1 | 0.036 | 8.4107 | 4.482 | 47.8 | 7.3 | 105.5 |

| | Ferrite powder | | | | | | | | | | | | |
|---|---|---|---|---|---|---|---|---|---|---|---|---|---|
| | Particle size distribution | | | SF-2 | Aspect ratio | True specific gravity (g/cm$^3$) | Crystal phase | | $I_{222}/I_{311}$ | Lattice constant LCp (A) | Crystallite diameter CSp (nm) | Magnetic properties (@5kOe) | | |
| | D10 (μm) | D50 (μm) | D90 (μm) | | | | Spinel phase (mass%) | α-Fe$_2$O$_3$ (mass%) | | | | σs (emu/g) | σr (emu/g) | Hc (Oe) |
| Example 13* | 0.4 | 0.9 | 1.8 | 1.15 | 1.57 | 5.18 | 86.1 | 13.9 | 0.028 | 8.4903 | 2.955 | 67.8 | 10.0 | 117.3 |
| Example 14* | 1.4 | 5.0 | 10.2 | 1.15 | 1.49 | 5.15 | 99.4 | 0.6 | 0.042 | 8.4950 | 16.025 | 85.6 | 4.2 | 50.6 |
| Example 15* | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 16* | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 17 | 1.4 | 5.0 | 10.2 | 1.16 | 1.49 | 5.15 | 99.4 | 0.6 | 0.042 | 8.4950 | 16.025 | 85.6 | 4.2 | 50.6 |
| Example 18 | 1.1 | 4.2 | 10.6 | 1.16 | 1.52 | 5.32 | 99.3 | 0.7 | 0.042 | 8.4821 | 16.852 | 57.8 | 2.0 | 24.4 |
| Example 19 | 1.1 | 4.2 | 9.5 | 1.24 | 1.52 | 5.36 | 99.2 | 0.8 | 0.042 | 8.4776 | 16.428 | 69.2 | 3.1 | 39.2 |
| Example 20 | 0.8 | 4.1 | 11.0 | 1.14 | 1.67 | 5.47 | 99.7 | 0.3 | 0.046 | 8.4043 | 16.682 | 57.3 | 4.0 | 57.2 |
| Example 21 | 0.9 | 4.5 | 11.5 | 1.12 | 1.57 | 5.54 | 99.6 | 0.4 | 0.046 | 8.4104 | 17.724 | 50.8 | 3.0 | 43.1 |
| Example 22 | 1.1 | 5.0 | 11.7 | 1.31 | 1.64 | 5.56 | 99.6 | 0.4 | 0.046 | 8.4028 | 16.508 | 59.5 | 4.1 | 57.9 |
| Example 23 | 1.3 | 3.6 | 9.0 | 1.21 | 1.53 | 5.07 | 99.4 | 0.6 | 0.042 | 8.4839 | 14.603 | 65.5 | 6.0 | 75.4 |
| Example 24 | 1.6 | 5.2 | 11.8 | 1.11 | 1.71 | 5.40 | 99.5 | 0.5 | 0.042 | 8.4104 | 10.711 | 95.5 | 11.6 | 151.7 |

| | Ferrite powder | | | | | | | | | | | | | |
| | Particle size distribution | | | SF-2 | Aspect ratio | True specific gravity (g/cm³) | Crystal phase | | $I_{222}/I_{311}$ | Lattice constant LCp (A) | Crystallite diameter CSp (nm) | Magnetic properties (@5kOe) | | |
| | D10 (μm) | D50 (μm) | D90 (μm) | | | | Spinel phase (mass%) | $\alpha$-$Fe_2O_3$ (mass%) | | | | σs (emu/g) | or (emu/g) | Hc (Oe) |
| Example 25 | 1.6 | 5.2 | 11.9 | 1.11 | 1.70 | 5.39 | 99.4 | 0.6 | 0.042 | 8.4127 | 11.187 | 94.8 | 0.7 | 142.9 |
| Note 1) "*" indicates a comparative example. | | | | | | | | | | | | | | |

Table 4 Properties of resin base material

| | | Resin base material | | | | |
|---|---|---|---|---|---|---|
| | Material | Specific gravity of resin (g/cm$^3$) | Thickness $d_R$ ($\mu$m) | Color tone | Surface roughness Sa ($\mu$m) | Surface resistance ($\Omega$) |
| Example 1 | PC | 1.20 | 500 | Colorless/ transparent | 0.10 | $1.0\times10^8$ or more |
| Example 2 | PC | 1.20 | 500 | Colorless/ transparent | 0.10 | $1.0\times10^8$ or more |
| Example 3 | PI | 1.42 | 50 | Brown/ transparent | 0.35 | $1.0\times10^8$ or more |
| Example 4 | PVC | 1.40 | 500 | Colorless/ transparent | 0.34 | $1.0\times10^8$ or more |
| Example 5 | POM | 1.41 | 500 | White/ opaque | 0.22 | $1.0\times10^8$ or more |
| Example 6 | ABS | 1.04 | 500 | Milky white/ opaque | 0.20 | $1.0\times10^8$ or more |
| Example 7 | PEEK | 1.32 | 5,000 | Gray/ opaque | 0.49 | $1.0\times10^8$ or more |
| Example 8 | PA | 1.10 | 5,000 | Blue/opaque | 0.81 | $1.0\times10^8$ or more |
| Example 9* | PP | 0.91 | 500 | White/ translucent | 0.50 | $1.0\times10^8$ or more |
| Example 10* | PMMA | 1.19 | 500 | Colorless/ transparent | 0.08 | $1.0\times10^8$ or more |
| Example 11 | PC | 1.20 | 500 | Colorless/ transparent | 0.10 | $1.0\times10^8$ or more |
| Example 12* | PC | 1.20 | 500 | Colorless/ transparent | 0.10 | $1.0\times10^8$ or more |
| Example 13* | PC | 1.20 | 500 | Colorless/ transparent | 0.10 | $1.0\times10^8$ or more |
| Example 14* | PC | 1.20 | 500 | Colorless/ transparent | 0.10 | $1.0\times10^8$ or more |
| Example 15* | PC | 1.20 | 500 | Colorless/ transparent | 0.10 | $1.0\times10^8$ or more |
| Example 16* | PC | 1.20 | 500 | Colorless/ transparent | 0.10 | $1.0\times10^8$ or more |
| Example 17 | PI | 1.42 | 50 | Brown/ transparent | 0.35 | $1.0\times10^8$ or more |
| Example 18 | PI | 1.42 | 50 | Brown/ transparent | 0.35 | $1.0\times10^8$ or more |
| Example 19 | PI | 1.42 | 50 | Brown/ transparent | 0.35 | $1.0\times10^8$ or more |
| Example 20 | PI | 1.42 | 50 | Brown/ transparent | 0.35 | $1.0\times10^8$ or more |

(continued)

| | Resin base material | | | | | |
|---|---|---|---|---|---|---|
| | Material | Specific gravity of resin (g/cm$^3$) | Thickness $d_R$ ($\mu$m) | Color tone | Surface roughness Sa ($\mu$m) | Surface resistance ($\Omega$) |
| Example 21 | PI | 1.42 | 50 | Brown/ transparent | 0.35 | $1.0 \times 10^8$ or more |
| Example 22 | PI | 1.42 | 50 | Brown/ transparent | 0.35 | $1.0 \times 10^8$ or more |
| Example 23 | PI | 1.42 | 50 | Brown/ transparent | 0.35 | $1.0 \times 10^8$ or more |
| Example 24 | PI | 1.42 | 50 | Brown/ transparent | 0.35 | $1.0 \times 10^8$ or more |
| Example 25 | PI | 1.42 | 50 | Brown/ transparent | 0.35 | $1.0 \times 10^8$ or more |
| Note 1) "*" indicates a comparative example. | | | | | | |

Table 5 Properties of magnetic composite

| | Ferrite layer | | | | | | | | | | | | | | | |
|---|---|---|---|---|---|---|---|---|---|---|---|---|---|---|---|---|
| | Thickness $d_F$ (µm) | | Thickness ratio $d_F/d_R$ | Density (g/cm$^3$) | Relative density (%) | Sa (µm) | Sz (µm) | Sa/$d_F$ | Composition (mass%) | | $I_{222}/I_{311}$ | Lattice constant LCf (Å) | Crystallite diameter CSf (nm) | Lattice constant change rate LCf/LCp | Crystallite diameter change rate CSf/CSp | Surface resistance (Ω) |
| | Surface | Back surface | | | | | | | Spinel phase | α-Fe$_2$O$_3$ | | | | | | |
| Example 1 | 4.10 | - | 0.0082 | 4.71 | 91.5 | 0.16 | 3.68 | 0.038 | 87.9 | 12.1 | 0.00 | 8.4923 | 2.1862 | 1.00 | 0.14 | 8.87×10$^5$ |
| Example 2 | 7.94 | - | 0.0159 | 4.54 | 88.2 | 0.24 | 1.94 | 0.030 | 85.9 | 14.1 | 0.00 | 8.4896 | 2.1328 | 1.00 | 0.13 | 1.49×10$^5$ |
| Example 3 | 4.10 | - | 0.0820 | 4.34 | 84.3 | 0.18 | 2.70 | 0.044 | 90.1 | 9.9 | 0.00 | 8.4495 | 1.8842 | 0.99 | 0.12 | 7.32×10$^5$ |
| Example 4 | 5.20 | - | 0.0104 | 4.99 | 97.0 | 0.25 | 3.99 | 0.048 | 86.4 | 13.6 | 0.00 | 8.4911 | 2.1850 | 1.00 | 0.14 | 1.15×10$^5$ |
| Example 5 | 6.00 | - | 0.0120 | 4.63 | 89.9 | 0.22 | 2.85 | 0.036 | 85.3 | 14.7 | 0.00 | 8.4903 | 2.1745 | 1.00 | 0.14 | 4.95×10$^4$ |
| Example 6 | 5.90 | - | 0.0118 | 4.58 | 89.0 | 0.20 | 3.32 | 0.034 | 88.4 | 11.6 | 0.00 | 8.4969 | 2.1541 | 1.00 | 0.13 | 3.03×10$^5$ |
| Example 7 | 6.19 | - | 0.0031 | 4.83 | 93.8 | 0.56 | 5.49 | 0.090 | 87.8 | 12.2 | 0.00 | 8.4902 | 2.1489 | 1.00 | 0.13 | 5.39×10$^4$ |
| Example 8 | 7.63 | - | 0.0038 | 4.72 | 91.7 | 0.88 | 8.15 | 0.115 | 85.1 | 14.9 | 0.00 | 8.4899 | 2.1654 | 1.00 | 0.14 | 4.32×10$^5$ |
| Example 9* | 2.70 | - | 0.0054 | 2.21 | 42.9 | 0.52 | 4.89 | 0.193 | 90.4 | 9.6 | 0.04 | 8.4623 | 1.9942 | 1.00 | 0.12 | 1.0×10$^8$ or more |
| Example 10* | <0.01 | - | - | - | - | 0.09$^{Note1}$ | 2.03$^{Note1}$ | - | - | - | - | - | - | - | - | 1.0x10= or more$^{Note 1}$ |
| Example 11 | 4.21 | - | 0.0084 | 4.52 | 81.5 | 0.12 | 2.15 | 0.029 | 99.5 | 0.5 | 0.00 | 8.3954 | 1.9070 | 1.00 | 0.11 | 1.0×10$^8$ or more |
| Example 12* | <0.01 | - | - | - | - | 0.11$^{Note 1}$ | 3.5$^{Note 1}$ | - | - | - | - | - | - | - | - | 1.0×10$^8$ or more$^{Note 1}$ |

| | Ferrite layer | | | | | | | | | | | | | | | |
| | Thickness $d_F$ (μm) | | Thickness ratio $d_F/d_R$ | Density (g/cm³) | Relative density (%) | Sa (μm) | Sz (μm) | Sa/$d_F$ | Composition (mass%) | | $I_{222}/I_{311}$ | Lattice constant LCf (A) | Crystallite diameter CSf (nm) | Lattice constant change rate LCf/LCp | Crystallite diameter change rate CSf/CSp | Surface resistance (Ω) |
| | Surface | Back surface | | | | | | | Spinel phase | α-$Fe_2O_3$ | | | | | | |
| Example 13* | <0.01 | - | - | - | - | 0.12[Note 1] | 3.41[Note 1] | - | - | - | - | - | - | - | - | $1.0\times10^8$ or more[Note 1] |
| Example 14* | <0.01 | - | - | - | - | 0.14[Note 1] | 3.43[Note 1] | - | - | - | - | - | - | - | - | $1.0\times10^8$ or more[Note 1] |
| Example 15* | <0.01 | - | - | - | - | 0.12[Note 1] | 3.51[Note 1] | - | - | - | - | - | - | - | - | $1.0\times10^8$ or more[Note 1] |
| Example 16* | <0.01 | - | - | - | - | 0.11[Note 1] | 3.53[Note 1] | - | - | - | - | - | - | - | - | $1.0\times10^8$ or more[Note 1] |
| Example 17 | 4.10 | 4.10 | 0.0820 | 4.55 | 88.4 | 0.16 | 2.51 | 0.039 | 86.4 | 13.6 | 0.00 | 8.4870 | 1.9114 | 1.00 | 0.12 | $5.32\times10^5$ |
| Example 18 | 4.40 | 4.40 | 0.0880 | 4.46 | 83.8 | 0.21 | 3.05 | 0.048 | 82.6 | 17.4 | 0.00 | 8.4824 | 1.9036 | 1.00 | 0.11 | $6.58\times10^5$ |
| Example 19 | 4.35 | 4.35 | 0.0870 | 4.29 | 80.0 | 0.27 | 3.15 | 0.062 | 81.9 | 18.1 | 0.00 | 8.4791 | 1.8878 | 1.00 | 0.11 | $1.14\times10^6$ |
| Example 20 | 3.90 | 3.90 | 0.0780 | 4.38 | 80.1 | 0.19 | 2.38 | 0.049 | 90.1 | 9.9 | 0.00 | 8.4746 | 1.9031 | 1.01 | 0.11 | $1.0\times10^8$ or more |
| Example 21 | 9.60 | 3.60 | 0.0720 | 4.71 | 85.0 | 0.18 | 2.99 | 0.050 | 88.5 | 11.5 | 0.00 | 8.4710 | 1.8554 | 1.01 | 0.10 | $1.0\times10^8$ or more |
| Example 22 | 3.30 | 3.30 | 0.0660 | 4.31 | 77.5 | 0.21 | 3.47 | 0.064 | 92.3 | 7.7 | 0.00 | 8.4653 | 1.8389 | 1.01 | 0.11 | $1.0\times10^8$ or more |
| Example 23 | 3.80 | 3.80 | 0.0760 | 4.02 | 79.3 | 0.19 | 2.88 | 0.050 | 80.3 | 19.7 | 0.00 | 8.4940 | 1.7894 | 1.00 | 0.12 | $1.0\times10^8$ or more |
| Example 24 | 3.85 | 3.85 | 0.0770 | 4.11 | 76.1 | 0.23 | 3.18 | 0.060 | 97.2 | 2.8 | 0.00 | 8.4931 | 2.0401 | 1.01 | 0.19 | $2.47\times10^4$ |

EP 4 293 690 A1

| | Ferrite layer | | | | | | | | | | | | | | | |
|---|---|---|---|---|---|---|---|---|---|---|---|---|---|---|---|---|
| | Thickness $d_F$ (µm) | | Thickness ratio $d_F/d_R$ | Density (g/cm³) | Relative density (%) | Sa (µm) | Sz (µm) | Sa/$d_F$ | Composition (mass%) | | $I_{222}/I_{311}$ | Lattice constant LCf (A) | Crystallite diameter CSf (nm) | Lattice constant change rate LCf/LCp | Crystallite diameter change rate CSf/CSp | Surface resistance (Ω) |
| | Surface | Back surface | | | | | | | Spinel phase | α-Fe$_2$O$_3$ | | | | | | |
| Example 25 | 3.70 | 3.70 | 0.0740 | 4.21 | 78.1 | 0.27 | 3.61 | 0.073 | 98.5 | 1.5 | 0.00 | 8.4873 | 2.1769 | 1.01 | 0.19 | 3.52×10⁴ |

Note 1) Measurement value in a state where substantially no ferrite film is formed.
Note 2) "*" indicates a comparative example.
Note 3) "-" indicates that measurement is not conducted.

EP 4 293 690 A1

Table 6 Properties of magnetic composite

| | Magnetic properties | | | Permeability | | | Adhesion | | Bendability | | |
|---|---|---|---|---|---|---|---|---|---|---|---|
| | σs (emu/g) | or (emu/g) | Hc (Oe) | $\mu'$ | $\mu''$ | tanδ | Pencil hardness | Cross cut test | 1/16 inch | 118 inch | 114 inch |
| Example 1 | 2.7 | 0.1 | 177.1 | 2.78 | 0.58 | 0.21 | 8H | A | - | - | - |
| Example 2 | 4.9 | 0.2 | 181.9 | 2.91 | 0.61 | 0.21 | 8H | A | - | - | - |
| Example 3 | 7.9 | 2.9 | 140.3 | 2.87 | 0.65 | 0.23 | 7H | - | ○ | ○ | ○ |
| Example 4 | 3.1 | 0.2 | 207.6 | 2.84 | 0.67 | 0.24 | 8H | A | - | - | - |
| Example 5 | 3.2 | 0.2 | 209.6 | 2.83 | 0.62 | 0.22 | 10H | A | - | - | - |
| Example 6 | 4.2 | 0.2 | 156.4 | 2.64 | 0.51 | 0.19 | 6H | B | - | - | - |
| Example 7 | 1.0 | 0.0 | 761.3 | 2.74 | 0.57 | 0.21 | 10H | A | - | - | - |
| Example 8 | 1.4 | 0.1 | 637.3 | 2.73 | 0.55 | 0.20 | 5H | B | - | - | - |
| Example 9* | 1.1 | 0.1 | 131.8 | 1.42 | 0.25 | 0.17 | H | D | - | - | - |
| Example 10* | - | - | - | - | - | - | HB[Note 1] | - | - | - | - |
| Example 11 | 1.6 | 0.1 | 150.9 | 1.99 | 0.41 | 0.21 | 7H | A | - | - | - |
| Example 12* | - | - | - | - | - | - | B[Note 1] | - | - | - | - |
| Example 13* | - | - | - | - | - | - | B[Note 1] | - | - | - | - |
| Example 14* | - | - | - | - | - | - | B[Note 1] | - | - | - | - |
| Example 15* | - | - | - | - | - | - | B[Note 1] | - | - | - | - |
| Example 16* | - | - | - | - | - | - | B[Note 1] | - | - | - | - |
| Example 17 | 17.7 | 6.4 | 140.9 | 2.98 | 0.64 | 0.22 | 8H | - | ○ | ○ | ○ |
| Example 18 | 18.1 | 5.5 | 120.5 | 2.81 | 0.91 | 0.33 | 7H | - | ○ | ○ | ○ |
| Example 19 | 19.7 | 4.2 | 113.7 | 3.40 | 1.41 | 0.41 | 8H | - | ○ | ○ | ○ |
| Example 20 | 7.9 | 2.6 | 240.4 | 1.94 | 0.28 | 0.14 | 7H | - | ○ | ○ | ○ |

(continued)

| | Magnetic properties | | | Permeability | | | Adhesion | | Bendability | | |
|---|---|---|---|---|---|---|---|---|---|---|---|
| | $\sigma s$ (emu/g) | or (emu/g) | Hc (Oe) | $\mu'$ | $\mu''$ | $\tan\delta$ | Pencil hardness | Cross cut test | 1/16 inch | 118 inch | 114 inch |
| Example 21 | 7.6 | 3.1 | 237.5 | 2.06 | 0.44 | 0.21 | 8H | - | ○ | ○ | ○ |
| Example 22 | 8.1 | 3.6 | 273.8 | 1.98 | 0.22 | 0.11 | 7H | - | ○ | ○ | ○ |
| Example 23 | 9.1 | 3.0 | 195.6 | 2.34 | 0.52 | 0.22 | 8H | - | ○ | ○ | ○ |
| Example 24 | 18.1 | 7.9 | 334.2 | 1.86 | 0.05 | 0.03 | 7H | - | ○ | ○ | ○ |
| Example 25 | 15.6 | 6.6 | 319.9 | 2.36 | 0.13 | 0.05 | 7H | - | ○ | ○ | ○ |

Note 1) Measurement value in a state where substantially no ferrite film is formed.
Note 2) "*" indicates a comparative example.
Note 3) "-" indicates that measurement is not conducted.

INDUSTRIAL APPLICABILITY

According to the present invention, there is provided a magnetic composite including a ferrite layer that is dense, has a relatively large film thickness, is excellent in magnetic properties and electrical properties, and further has good adhesion.

The present invention has been described in detail with reference to specific embodiments, but it is apparent to those skilled in the art that various changes and modifications can be made without departing from the spirit and scope of the present invention.

The present application is based on the Japanese patent application (Japanese Patent Application No. 2021-018761) filed on February 9, 2021, the Japanese patent application (Japanese Patent Application No. 2022-017459) filed on February 7, 2022, and the Japanese patent application (Japanese Patent Application No. 2022-018310) filed on February 8, 2022, and the contents thereof are incorporated herein by reference.

REFERENCE SIGNS LIST

2: aerosolization chamber
4: film formation chamber
6: conveying gas source
8: vacuum evacuation system
10: vibrator
12: raw material container
14: nozzle
16: stage
20: aerosol deposition film forming device

**Claims**

1. A magnetic composite comprising a resin base material and a ferrite layer provided on a surface of the resin base material, wherein

the resin base material has a thickness ($d_R$) of 10 $\mu$m or more, and

the ferrite layer has a thickness ($d_F$) of 2.0 $\mu$m or more, contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis.

2. The magnetic composite according to claim 1, wherein
in the ferrite layer, a content of $\alpha$-$Fe_2O_3$ is 0.0 mass% or more and 20.0 mass% or less.

3. The magnetic composite according to claim 1 or 2, wherein
the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

4. The magnetic composite according to any one of claims 1 to 3, wherein
in the ferrite layer, a ratio ($Sa/d_F$) of a surface arithmetic mean height (Sa) to the thickness ($d_F$) is more than 0.00 and 0.20 or less.

5. The magnetic composite according to any one of claims 1 to 4, wherein
the ferrite layer has a composition including a ferrite component and the remainder being inevitable impurities.

6. The magnetic composite according to any one of claims 1 to 5, wherein
a specific gravity of a resin constituting the resin base material is 0.95 g/cm$^3$ or more.

7. The magnetic composite according to any one of claims 1 to 6, wherein
a resin constituting the resin base material is at least one selected from the group consisting of polycarbonate (PC), polyimide (PI), polyvinyl chloride (PVC), polyoxymethylene (POM), acrylonitrile butadiene styrene (ABS), polyetheretherketone (PEEK), and polyamide (PA).

## FIG. 1

FERRITE FILM

RESIN BASE MATERIAL

## FIG. 2

FERRITE FILM

RESIN BASE MATERIAL

## FIG. 3

FERRITE FILM

FERRITE FILM

RESIN BASE MATERIAL

## FIG. 4

FERRITE FILM

RESIN BASE MATERIAL

## FIG. 5

COIL (SPIRAL SHAPE, METAL)

FERRITE FILM

BASE MATERIAL
BACK SIDE ELECTRODE

RESIN BASE MATERIAL

THROUGH ELECTRODE
(FROM SPIRAL COIL TO BASE MATERIAL SIDE ELECTRODE)

FIG. 6

*FIG. 7*

(a)

FERRITE FILM

FERRITE FILM

(b)

INDUCTOR ELECTRODE
INDUCTOR ELECTRODE

FIG. 8

ANTENNA PATTERN
(METAL CONDUCTOR)

FERRITE FILM

RESIN BASE MATERIAL

ID TAG CHIP

FIG. 9

FIG. 10

FIG. 11

EP 4 293 690 A1

## INTERNATIONAL SEARCH REPORT

| International application No. |
|---|
| **PCT/JP2022/005026** |

**A. CLASSIFICATION OF SUBJECT MATTER**

*H01F 10/20*(2006.01)i; *H01F 1/00*(2006.01)i; *H01F 1/34*(2006.01)i; *H01F 41/16*(2006.01)i; *H05K 9/00*(2006.01)i
FI: H01F10/20; H01F1/00 127; H01F1/34 140; H01F41/16; H05K9/00 M

According to International Patent Classification (IPC) or to both national classification and IPC

**B. FIELDS SEARCHED**

Minimum documentation searched (classification system followed by classification symbols)

H01F10/20; H01F1/00; H01F1/34; H01F41/16; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2007-174462 A (FUJIKURA LTD) 05 July 2007 (2007-07-05)<br>paragraphs [0011]-[0018], [0030], [0035]-[0042], fig. 1 | 1-7 |
| Y | JP 2003-297628 A (SONY CORP) 17 October 2003 (2003-10-17)<br>paragraphs [0022]-[0027], [0040], fig. 1 | 1-7 |
| A | JP 2003-297629 A (SONY CORP) 17 October 2003 (2003-10-17)<br>paragraphs [0015]-[0043], fig. 1-5 | 1-7 |
| A | 小林亮平, 杉本諭, 籠谷登志夫, 猪俣浩一郎, 明渡純, 岡山克巳, エアロゾル・デポジション法により作製したNi-Zn-Cuフェライト厚膜の高周波特性, 粉体および粉末冶金, 2004, vol. 51, no. 9, pp. 691-697, ISSN 0532-8799<br>entire text, (KOBAYASHI, Ryohei. SUGIMOTO, Satoshi. KAGOTANI, Toshio. INOMATA, Koichiro. AKEDO, Jun. OKAYAMA, Katsumi. High Frequency Properties of Ni-Zn-Cu Ferrite Thick Films Prepared by Aerosol Deposition Method. Journal of the Japan Society of Powder and Powder Metallurgy.) | 1-7 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 May 2022** | **17 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/005026**

| Patent document cited in search report | | | Publication date (day/month/year) | Patent family member(s) | Publication date (day/month/year) |
|---|---|---|---|---|---|
| JP | 2007-174462 | A | 05 July 2007 | (Family: none) | |
| JP | 2003-297628 | A | 17 October 2003 | (Family: none) | |
| JP | 2003-297629 | A | 17 October 2003 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005045193 A
- JP 2006175375 A
- JP 2006269675 A

- JP 2021018761 A
- JP 2022017459 A
- JP 2022018310 A